# EUROPEAN PATENT SPECIFICATION

(11) **EP 3 961 733 B1**
(45) Date of publication and mention of the grant of the patent: **03.09.2025**
(21) Application number: 20795038.7
(22) Date of filing: 27.04.2020
(51) Int. Cl.: H10N 15/00

(54) **THERMOELECTRIC CONVERSION ELEMENT AND THERMOELECTRIC CONVERSION DEVICE**
THERMOELEKTRISCHES UMWANDLUNGSELEMENT UND THERMOELEKTRISCHE UMWANDLUNGSVORRICHTUNG
ÉLÉMENT DE CONVERSION THERMOÉLECTRIQUE ET DISPOSITIF DE CONVERSION THERMOÉLECTRIQUE

(30) Priority: 26.04.2019 JP 2019086716; 07.11.2019 US 201962931892 P
(43) Date of publication of application: 02.03.2022
(73) Proprietor: The University of Tokyo, Bunkyo-ku Tokyo 113-8654 (JP)
(72) Inventor: NAKATSUJI, Satoru, Tokyo 113-8654 (JP); SAKAI, Akito, Tokyo 113-8654 (JP); HIGO, Tomoya, Tokyo 113-8654 (JP)
(74) Representative: Bandpay & Greuter
(86) International application number: PCT/JP2020/018010
(87) International publication number: WO 2020/218613

(56) References cited:
- WO-A1-2019/009308
- JP-A- 2014 072 256
- JP-A- 2017 084 854
- JP-A- 2018 078 147
- US-A1- 2022 052 247
- YANG Z ET AL: "Scalable Nernst thermoelectric power using a coiled galfenol wire", AIP ADVANCES, vol. 7, 095017, 20 September 2017 (2017-09-20), XP012222078, DOI: 10.1063/1.5003611
- ISOGAMI S ET AL: "Dependence of anomalous Nernst effect on crystal orientation in highly ordered gamma'-Fe4N films with anti-perovskite structure", APPLIED PHYSICS EXPRESS, vol. 10, 073005, 23 June 2017 (2017-06-23), XP055719877, DOI: 10.7567/APEX.10.073005
- NAKAYAMA H ET AL: "Mechanism of strong enhancement of anomalous Nernst effect in Fe by Ga substitution", PHYSICAL REVIEW MATERIALS, vol. 3, 114412, 25 November 2019 (2019-11-25), XP093056594, DOI: 10.1103/PhysRevMaterials.3.114412
- SAKAI A ET AL: "Iron-based binary ferromagnets for transverse thermoelectric conversion", NATURE, vol. 581, no. 7806, 27 April 2020 (2020-04-27), pages 53 - 57, XP037183243, DOI: 10.1038/S41586-020-2230-Z
- HAMADA Y ET AL: "Anomalous Nernst effect in Fe-Si alloy films", APPLIED PHYSICS LETTERS, vol. 119, 152404, 12 October 2021 (2021-10-12), XP012260287, DOI: 10.1063/5.0062637
- K. HAMAYA, T. MURAKAMI, S. YAMADA, K. MIBU, M. MIYAO: "Local structural ordering in low-temperature-grown epitaxial Fe3+xSil-x films on Ge(111)", PHYSICAL REVIEW B, vol. 83, 14 April 2011 (2011-04-14), pages 144411-1 - 144411-6, XP055759633, DOI: 10.1103/PhysRevB.83.144411

## Description

### Technical Field

The present invention relates to a thermoelectric conversion element, and a thermoelectric conversion device including the thermoelectric conversion element.

### Background Art

The Seebeck effect is known as a thermoelectric mechanism that generates an electric voltage when a temperature gradient is applied to a material (see e.g., Patent Literature 1). Unfortunately, in the thermoelectric mechanism using the Seebeck effect, main materials usable at room temperature or more include bismuth, tellurium, lead or the like, and thus are not suitable for practical use due to high toxicity and are not durable due to mechanical fragility and vulnerability to vibration. The Seebeck effect generates the electric voltage in the same direction as the temperature gradient, which requires a complicated three-dimensional structure in which p-type modules and n-type modules are alternately arranged and stand in a direction perpendicular to a surface of a heat source. This leads to a rise in manufacturing cost. In addition, such a three-dimensional structure makes it difficult to achieve a large-area thermoelectric module.

Similarly, the anomalous Nernst effect is known as a thermoelectric mechanism that generates an electric voltage due to a temperature gradient. The anomalous Nernst effect is a phenomenon observed when a heat current flowing through a magnetic material creates a temperature difference, which generates an electric voltage in a direction perpendicular to both a magnetization direction and the temperature gradient. Recent studies have shown that topological electronic structures contribute to increasing a Nernst coefficient much higher than a previously known value (0.1 µV/K). For example, Non-patent Literature 1 discloses a scalable Nernst thermoelectric power generator using a Galfenol (Fe_{0.85}Ga_{0.15}) wire coiled around a hot cylinder. Non-patent Literature 2 investigates the anomalous Nernst effect in a highly ordered γ' -Fe₄N film with anti-perovskite structure, in comparison with disordered Fe-Al crystal films (A2-type Fe₁₀₀₋ₓAlₓ with x=4-30 at.%). Patent Literature 2 discloses a thermoelectric conversion device including a thermoelectric conversion element composed of an antiferromagnetic material having a non-collinear spin structure.

### Citation List

### Patent Literature

Patent Literature 1: WO 2016/181777
Patent Literature 2: JP 2017-84854 A

### Non-patent Literature

Non-patent Literature 1: YANG Z et al, "Scalable Nernst thermoelectric power using a coiled galfenol wire", AIP ADVANCES, vol. 7, 095017, 2017
Non-patent Literature 2: ISOGAMI S et al: "Dependence of anomalous Nernst effect on crystal orientation in highly ordered γ'-Fe4N films with anti-perovskite structure", APPLIED PHYSICS EXPRESS, vol. 10, 073005, 2017

### Summary of Invention

### Technical Problem

However, although various magnetic materials exhibiting the anomalous Nernst effect have been developed so far, such metal materials are relatively expensive, which leads to a high cost.

The present invention has been made in view of the foregoing, and an object of the invention is to provide a thermoelectric conversion element made of an inexpensive and non-toxic material, and a thermoelectric conversion device.

### Solution to Problem

A thermoelectric conversion element according to one aspect of the invention is made of: a first material with a stoichiometric composition of Fe₃X where X is a main-group element or a transition element; a second material with an off-stoichiometric composition in which a composition ratio of Fe to X deviates from that of the first material, the second material having a D0₃-type crystal structure or a B2-type crystal structure; a third material obtained by substituting a part of Fe sites in the first material or a part of Fe sites in the second material by a main-group metal element or a transition element other than X; a fourth material with a composition of Fe₃M1₁₋ₓM2ₓ where 0<x<1, and M1 and M2 are main-group elements different from each other; or a fifth material obtained by substituting a part of Fe sites in the first material by a transition element other than X and substituting a part of X sites in the first material by a main-group metal element other than X. The first material, the second material, the third material, the fourth material, and the fifth material exhibit an anomalous Nernst effect.

A thermoelectric conversion device according to one aspect of the invention includes a substrate and a power generator provided on the substrate and including a plurality of thermoelectric conversion elements. Each of the plurality of thermoelectric conversion elements has a shape extending in one direction, and is made of the first material, the second material, the third material, the fourth material, or the fifth material. The plurality of thermoelectric conversion elements are arranged in parallel to one another in a direction perpendicular to the one direction and electrically connected in series to one another.

A thermoelectric conversion device according to another aspect of the invention includes the thermoelectric conversion element described above and a hollow member. The thermoelectric conversion element is a sheet-shaped element or a wire rod covering an outer surface of the hollow member. Advantageous Effects of Invention

According to the present invention, a thermoelectric conversion element made of an inexpensive and non-toxic material is capable of exhibiting an anomalous Nernst effect.

### Brief Description of Drawings

FIG. 1 is a schematic view illustrating a D0₃-type crystal structure of Fe₃X and an L1₂-type crystal structure of Fe₃X.
FIG. 2 is a schematic view illustrating a thermoelectric mechanism using a thermoelectric conversion element of embodiments.
FIG. 3 is a graph illustrating temperature dependence of Nernst coefficients for various metal materials.
FIG. 4 is a graph illustrating each Nernst coefficient shown in FIG. 3 being normalized by a Nernst coefficient at T=300 K.
FIG. 5 is a graph illustrating magnetic field dependence of the Nernst coefficients at T=300 K for single crystals and a polycrystal of Fe-Al alloy, and a polycrystal of Fe-Al-V alloy.
FIG. 6 is a graph illustrating the temperature dependence of the Nernst coefficients for the single crystals and the polycrystal of the Fe-Al alloy, and the polycrystal of the Fe-Al-V alloy.
FIG. 7 is a perspective view illustrating a configuration of a thermoelectric conversion device according to Example 1 including the thermoelectric conversion element of the embodiments.
FIG. 8 is a plan view illustrating a configuration of a thermoelectric conversion device according to Example 2 including the thermoelectric conversion element of the embodiments.
FIG. 9 is an external view illustrating a configuration of a thermoelectric conversion device according to Example 3 including the thermoelectric conversion element of the embodiments.
FIG. 10 is a graph illustrating magnetic field dependence of Nernst coefficients at T=300 K for Fe₃Pt, Fe₃Ge, Fe₃Al, Fe₃Ga_{0.5}Al_{0.5}, Fe₃Ga, and Co₂MnGa.
FIG. 11 is a graph illustrating temperature dependence of the Nernst coefficients for Fe₃Pt, Fe₃Ge, Fe₃Al, Fe₃Ga, and Co₂MnGa.
FIG. 12A is a graph illustrating temperature dependence of a Nernst coefficient of Fe₃Sn.
FIG. 12B is a graph illustrating temperature dependence of a transverse thermoelectric conductivity of Fe₃Sn.
FIG. 13A is a table illustrating Nernst coefficients of mixed crystals of Fe₃Si and Fe₃Al at T=300 K.
FIG. 13B is a graph illustrating the Nernst coefficients of the mixed crystals of Fe₃Si and Fe₃Al at T=300 K.
FIG. 14A is a table illustrating Nernst coefficients of mixed crystals of Fe₃Al and Fe₃Ga at T=300 K.
FIG. 14B is a graph illustrating the Nernst coefficients of the mixed crystals of Fe₃Al and Fe₃Ga at T=300 K.
FIG. 15 is a graph illustrating Nernst coefficients of single crystals and a polycrystal of Fe₃Cu₁₋ₓGaₓ obtained by substituting a part of Ga sites of Fe₃Ga by Cu, at T=300 K.
FIG. 16A is a graph illustrating X-ray diffraction patterns of Nd_{0.1}Fe_{2.9}Ga and Fe₃Ga.
FIG. 16B is a graph illustrating magnetic field dependence of magnetization of Nd_{0.1}Fe_{2.9}Ga at T=300 K.
FIG. 16C is a graph illustrating the magnetic field dependence of the Nernst coefficients at T=300 K for a single crystal of Fe₃Ga and a polycrystal of Nd_{0.1}Fe_{2.9}Ga.
FIG. 16D is a graph illustrating the magnetic field dependence of Hall resistivity at T=300 K for the single crystal of Fe₃Ga and the polycrystal of Nd_{0.1}Fe_{2.9}Ga.
FIG. 17A is a graph illustrating X-ray diffraction patterns of Ho_{0.05}Fe_{2.95}Ga and Fe₃Ga.
FIG. 17B is a graph illustrating magnetic field dependence of magnetization of Ho_{0.05}Fe_{2.95}Ga at T=300 K.
FIG. 18A is a graph illustrating X-ray diffraction patterns of Y_{0.05}Fe_{2.95}Ga and Fe₃Ga.
FIG. 18B is a graph illustrating magnetic field dependence of magnetization of Y_{0.05}Fe_{2.95}Ga.
FIG. 19A is a graph illustrating magnetic field dependence of magnetization of Tb_{0.05}Fe_{2.95}Ga.
FIG. 19B is a graph illustrating an enlarged view in a low magnetic field region of FIG. 19A.
FIG. 20A is a graph illustrating X-ray diffraction patterns of Tb_{0.03}Fe_{2.97}Ga and Fe₃Ga.
FIG. 20B is a graph illustrating magnetic field dependence of magnetization of Tb_{0.03}Fe_{2.97}Ga at T=300 K.
FIG. 21A is a graph illustrating X-ray diffraction patterns of Fe₃Ga_{0.8}B_{0.2}, Fe₃Ga_{0.9}B_{0.1}, and Fe₃Ga.
FIG. 21B is a graph illustrating magnetic field dependence of magnetization at T=300 K for a needle-like sample and a plate-like sample, both of which are made of Fe₃Ga_{0.8}B_{0.2}.
FIG. 21C is a graph illustrating the magnetic field dependence of magnetization for the needle-like samples of Fe₃Ga_{0.8}B_{0.2} and Fe₃Ga.
FIG. 21D is a graph illustrating the magnetic field dependence of magnetization for the plate-like samples of Fe₃Ga_{0.8}B_{0.2} and Fe₃Ga.
FIG. 21E is a graph illustrating the magnetic field dependence of a Nernst coefficient for the plate-like sample of Fe₃Ga_{0.8}B_{0.2}.
FIG. 21F is a graph illustrating the magnetic field dependence of Hall resistivity for the plate-like sample of Fe₃Ga_{0.8}B_{0.2}.
FIG. 22A is a graph illustrating X-ray diffraction patterns of Fe_{2.9}Mn_{0.1}Ga, Fe_{2.5}Mn_{0.5}Ga, Fe₂MnGa, and Fe₃Ga.
FIG. 22B is a graph illustrating magnetic field dependence of magnetization at T=300 K for needle-like samples of Fe_{2.9}Mn_{0.1}Ga and Fe_{2.5}Mn_{0.5}Ga.
FIG. 23A is a graph illustrating X-ray diffraction patterns of Fe_{2.9}Pt_{0.1}Ga, Fe_{2.9}Pt_{0.1}Ga_{0.9}Ge_{0.1}, and Fe₃Ga.
FIG. 23B is a graph illustrating magnetic field dependence of magnetization at T=300 K for needle-like samples of Fe_{2.9}Pt_{0.1}Ga and Fe_{2.9}Pt_{0.1}Ga_{0.9}Ge_{0.1}.
FIG. 24 is a schematic view illustrating the anomalous Nernst effect when a temperature gradient is applied in an in-plane direction of a thin film sample as the thermoelectric conversion element.
FIG. 25 is a graph illustrating measurement results of the anomalous Nernst effect at T=300 K when a temperature gradient is applied to a thin film sample (Fe₃Ga) in the in-plane direction.
FIG. 26 is a schematic view illustrating the anomalous Nernst effect when a temperature gradient is applied in an out-of-plane direction to a thin film sample as the thermoelectric conversion element.
FIG. 27A is a schematic view illustrating a method of measuring the anomalous Nernst effect when a temperature gradient is applied to a thin film sample in the out-of-plane direction.
FIG. 27B is a schematic view illustrating the method of measuring the anomalous Nernst effect when the temperature gradient is applied to the thin film sample in the out-of-plane direction.
FIG. 28 is a graph illustrating the measurement results of the anomalous Nernst effect when a temperature gradient is applied to a thin film sample (Fe₃Ga) in the out-of-plane direction.
FIG. 29A is a graph illustrating measurement results of the anomalous Nernst effect when a temperature gradient is applied in the out-of-plane direction to a thin film sample of Fe₃Ga obtained without annealing after film growth at room temperature.
FIG. 29B is a graph illustrating an enlarged view in a low magnetic field region of FIG. 29A.
FIG. 30 is a graph illustrating the measurement results of the anomalous Nernst effect when a temperature gradient is applied in the out-of-plane direction, to a Fe₃Ga epitaxial film obtained through annealing after the film growth at room temperature, and to a Fe₃Ga amorphous film obtained without annealing after the film growth at room temperature.

### Description of Embodiments

Exemplary embodiments of the present invention will be described below with reference to the accompanying drawings.

Among materials exhibiting the anomalous Nernst effect, a Nernst coefficient of Co₂MnGa at room temperature reaches a record high value of 6 µV/K, reported by inventors of the present application (see Nature Physics 14, 1119-1124 (2018) and International Publication No. WO 2019/009308).

As described below, the inventors of the present application have been able to demonstrate that a Nernst coefficient of Fe₃Al, which is a binary compound, approaches the record high value. It is known that elements in descending order of Clarke number, which represents the weight ratio of the elements existing near the Earth's surface, are oxygen (O), silicon (Si), aluminum (Al), iron (Fe), .... As just described, Fe and Al are relatively large in Clarke number, and thus are very inexpensive and non-toxic materials. Furthermore, Fe₃Al is chemically stable and has a ferromagnetic transition temperature as high as about 700 K.

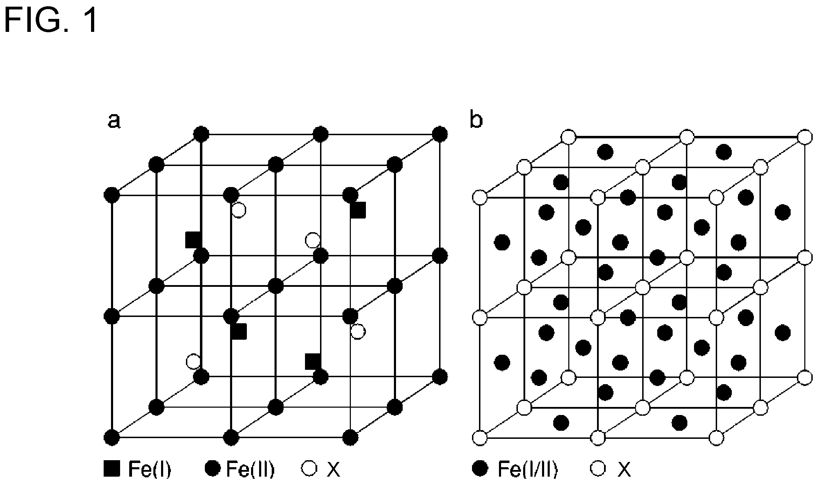

FIG. 1 shows a crystal structure of Fe₃X (where X is a main-group element or a transition element) which is capable of exhibiting the anomalous Nernst effect. As shown in FIG. 1, Fe₃X has a D0₃-type structure (a) and an L1₂-type structure (b).

A unit cell of the D0₃ structure (a) has eight body-centered cubic (bcc)-type subcells. In each subcell, Fe atoms (Fe(II)) occupy corner points, and each Fe (II) is shared by adjacent eight subcells. Four Fe atoms (Fe(I)) occupy body-centered points of four of the eight subcells, respectively, and four X atoms occupy body-centered points of the remaining four subcells, respectively. For example, a lattice constant "a" of Fe₃Al having the D0₃ structure is 5.64Å (see Physical Review B 66, 205203 (2002)).

The L1₂ structure (b) is a face-centered cubic (fcc)-type crystal structure in which Fe atoms are located at face-centered points, and X atoms are located at corner points.

For example, single crystals of Fe₃Al are prepared by arc-melting Fe and Al with an appropriate ratio, performing crystal growth by a Czochralski drawing method, annealing the crystals at low temperature (e.g., 500 °C), and performing slow cooling to room temperature for several minutes to several tens of minutes. Electron diffraction indicates that the prepared Fe₃Al single crystals are in an ordered phase (D0₃ phase (Fm-3m)).

Polycrystals of Fe₃Al are prepared by making polycrystalline samples through arc-melting of Fe and Al with an appropriate ratio, annealing the samples at high temperature (e.g., 900 °C), and performing rapid cooling to room temperature for several seconds. From the phase diagram, the prepared Fe₃Al polycrystals are considered to be in a disordered phase (B2 phase (Pm-3m) or A2 phase (Im-3m)) or mixed crystals in ordered and disordered phases.

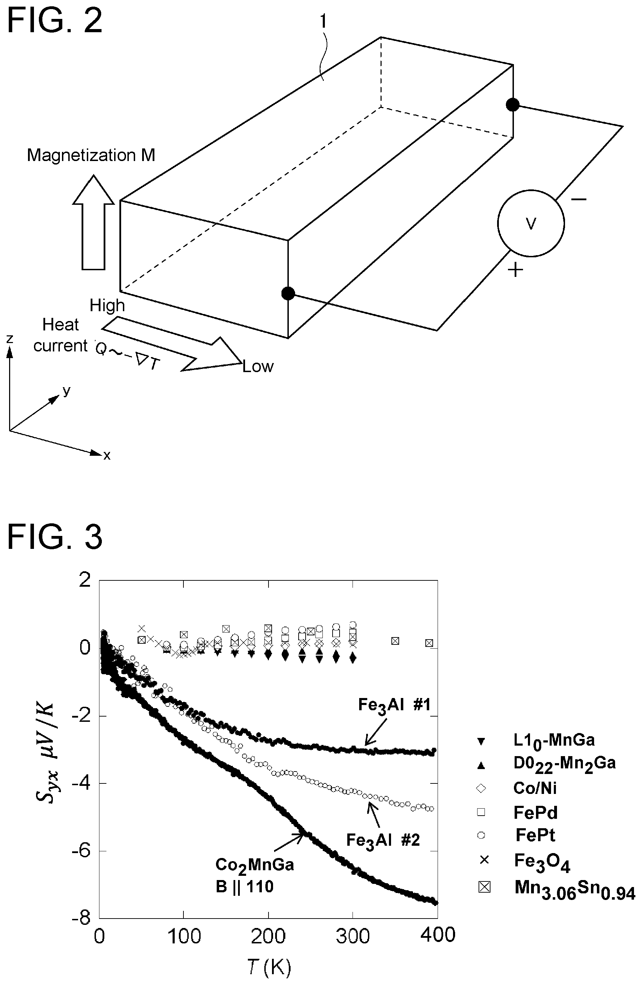

Next, a thermoelectric conversion element according to the embodiments of the present invention and a thermoelectric mechanism thereof will be described with reference to FIG. 2.

A thermoelectric conversion element 1 according to the embodiments is made of single crystals or polycrystals of Fe₃X which are prepared by the above-described method. As shown in FIG. 2, an assumption is made that the thermoelectric conversion element 1 has a rectangular parallelepiped shape extending in one direction (direction y), has a predetermined thickness (length in direction z), and is magnetized in a direction +z. When a heat current Q (~-∇T) flows through the thermoelectric conversion element 1 in a direction +x, a temperature difference is created in the direction +x. As a result, in the thermoelectric conversion element 1, the anomalous Nernst effect generates electromotive force V (~M×(-VT)) in an outer product direction (direction y) orthogonal to both the direction of the heat current Q (direction +x) and the direction of magnetization M (direction +z).

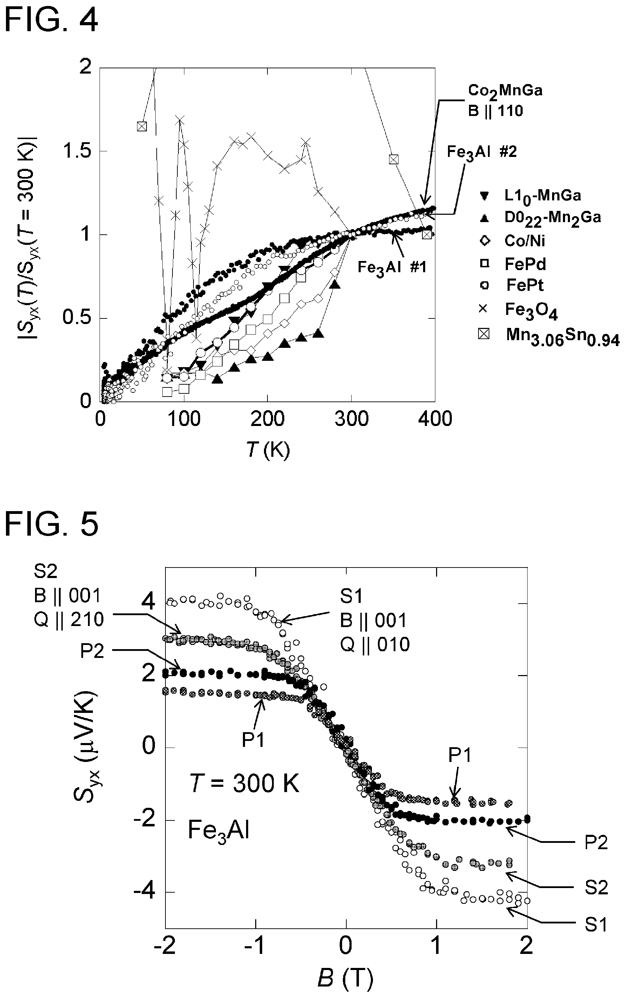

FIG. 3 shows comparison results between Nernst coefficients (S_{yx}) of the thermoelectric conversion elements 1 made of single crystals of Fe₃Al and Nernst coefficients of thermoelectric conversion elements made of other metal materials, illustrating temperature dependence of the Nernst coefficients. FIG. 4 is a graph in which the Nernst coefficient of each metal material shown in FIG. 3 is normalized by the Nernst coefficient at T=300 K.

In FIG. 3 and FIG. 4, Fe₃Al#1 represents an observational result of the thermoelectric conversion element 1 made of single crystals having an off-stoichiometric composition (Fe-rich, Al-poor) in which a composition ratio of Fe to Al deviates from 3:1, and Fe₃Al#2 represents an observational result of the thermoelectric conversion element 1 made of single crystals having a stoichiometric composition in which the composition ratio of Fe to Al is 3:1.

In FIG. 3 and FIG. 4, data of L1₀-type MnGa, D0₂₂-type Mn₂Ga, Co/Ni, FePd, and FePt is based on data disclosed in Appl. Phys. Lett. 106, 252405 (2015), and data of Fe₃O₄ is based on data disclosed in Physical Review B 90, 054422 (2014). Data of Co₂MnGa is based on the study by the inventors of the present application (see Nature Physics 14, 1119-1124 (2018); International Publication No. WO 2019/009308).

FIG. 3 and FIG. 4 suggest that absolute values |S_{yx}| of the Nernst coefficients of Fe₃Al#1 and Fe₃Al#2 are larger than those of any other metal materials except Co₂MnGa, and in particular, |S_{yx}| of stoichiometric Fe₃Al#2 is larger than that of off-stoichiometric Fe₃Al#1, reaching about 4 µV/K at room temperature (around T=300 K) and approaching |S_{yx}| of Co₂MnGa (≈6 µV/K).

Furthermore, FIG. 3 and FIG. 4 suggest that S_{yx} of off-stoichiometric Fe₃Al#1 is less affected by temperature change in a temperature range of 200 K to 400 K including room temperature, taking an almost constant value.

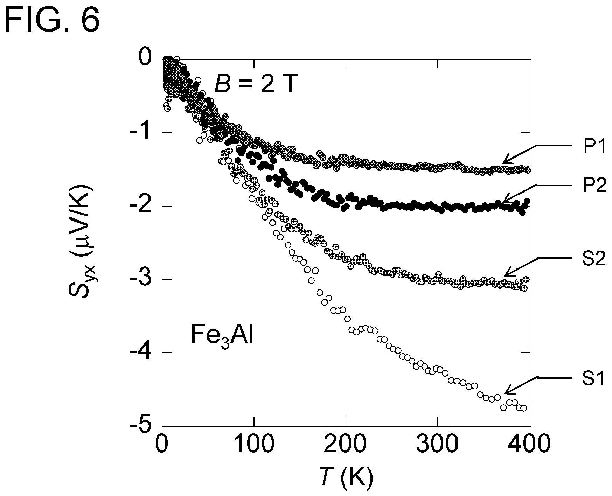

FIG. 5 shows magnetic field dependence of the Nernst coefficients (S_{yx}) at T=300 K for single crystals (S1 and S2) and a polycrystal (P2) of Fe-Al alloy, and a polycrystal (P1) of Fe-Al-V alloy, and FIG. 6 shows the temperature dependence of the Nernst coefficients for the single crystals (S1 and S2) and the polycrystal (P2) of the Fe-Al alloy and the polycrystal (P1) of the Fe-Al-V alloy, at a magnetic field B=2T.

In FIG. 5 and FIG. 6, S1 and S2 correspond to Fe₃Al#2 and Fe₃Al#1, respectively, shown in FIG. 3. S1 represents observational results when the magnetic field B parallel to [001] is applied to the thermoelectric conversion element 1, and the heat current Q parallel to [010] flows through the thermoelectric conversion element 1. S2 represents observational results when the magnetic field B parallel to [001] is applied to the thermoelectric conversion element 1, and the heat current Q parallel to [210] flows through the thermoelectric conversion element 1.

In FIG. 5 and FIG. 6, P1 represents an observational result in the thermoelectric conversion element 1 made of the polycrystal of Fe_{2.8}V_{0.15}Al obtained by substituting a part of Fe sites of Fe₃Al by vanadium (V), and P2 represents an observational result in the thermoelectric conversion element 1 made of the polycrystal having a stoichiometric composition in which the composition ratio of Fe to Al is 3:1.

FIG. 5 and FIG. 6 suggest that the single crystals (S1 and S2) have larger absolute values |S_{yx}| of the Nernst coefficients than the polycrystals (P1 and P2). Comparison between the polycrystals P1 and P2 indicates that | S_{yx} | of the stoichiometric binary polycrystal P2 is larger than that of the ternary polycrystal P1.

The Nernst coefficients of the polycrystals (P1 and P2) are less affected by temperature change in a temperature range of 200 K to 400 K including room temperature (around T=300 K) than those of the single crystals (S1 and S2), taking almost constant values. Although |S_{yx}| of the polycrystals (P1 and P2) is smaller than that of the single crystals (S1 and S2), |S_{yx}| at room temperature is about 1.5 to 2.0 µV/K, reaching a practical level for use in thermoelectric conversion devices such as heat flux sensors. As described above, the polycrystals (P1 and P2) are easier to prepare than the single crystals (S1 and S2).

Next, reference will be made to a thermoelectric conversion device in which the thermoelectric conversion element of the embodiments is modularized.

### Example 1

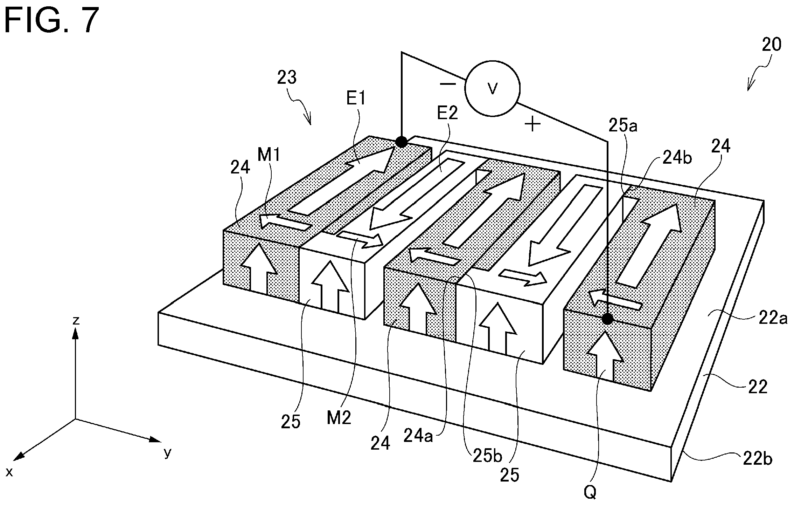

FIG. 7 shows an exterior configuration of a thermoelectric conversion device 20 according to Example 1 of the embodiments. The thermoelectric conversion device 20 includes a substrate 22 and a power generator 23 placed on the substrate 22. In the thermoelectric conversion device 20, when a heat current Q flows from the substrate 22 side toward the power generator 23, a temperature difference is created in the power generator 23 in the direction of the heat current, and an electric voltage V is generated in the power generator 23 by the anomalous Nernst effect.

The substrate 22 has a first surface 22a on which the power generator 23 is placed, and a second surface 22b opposite to the first surface 22a. Heat from a heat source (not shown) is applied onto the second surface 22b.

The power generator 23 includes a plurality of thermoelectric conversion elements 24 and a plurality of thermoelectric conversion elements 25, each having a three-dimensional L shape and being made of a material identical to that of the thermoelectric conversion element 1 shown in FIG. 2. As shown in FIG. 7, the thermoelectric conversion elements 24 and the thermoelectric conversion elements 25 are alternately arranged in parallel to one another on the substrate 22 in a direction (direction y) perpendicular to a longitudinal direction (direction x) of the thermoelectric conversion elements. The number of the thermoelectric conversion elements 24 and the thermoelectric conversion elements 25 constituting the power generator 23 is not limited.

The plurality of thermoelectric conversion elements 24 and the plurality of thermoelectric conversion elements 25 are arranged such that a direction of magnetization M1 of the thermoelectric conversion elements 24 is opposite to a direction of magnetization M2 of the thermoelectric conversion elements 25. The Nernst coefficient of the plurality of thermoelectric conversion elements 24 has the same sign as that of the plurality of thermoelectric conversion elements 25.

Each of the thermoelectric conversion elements 24 has a first end face 24a and a second end face 24b, both of which are parallel to the longitudinal direction (direction x). Each of the thermoelectric conversion elements 25 has a first end face 25a and a second end face 25b, both of which are parallel to the longitudinal direction (direction x). The first end face 25a of the thermoelectric conversion element 25 is connected to the second end face 24b of one adjacent thermoelectric conversion element 24, and the second end face 25b of the corresponding thermoelectric conversion element 25 is connected to the first end face 24a of another adjacent thermoelectric conversion element 24 on the opposite side. With this structure, the thermoelectric conversion elements 24 and the thermoelectric conversion elements 25 are electrically connected in series to one another. That is, the power generator 23 is provided on the first surface 22a of the substrate 22 in a serpentine shape.

When heat is applied from the heat source onto the second surface 22b of the substrate 22, the heat current Q flows in the direction +z toward the power generator 23. When the heat current Q creates a temperature difference, the anomalous Nernst effect causes each of the thermoelectric conversion elements 24 to generate an electromotive force E1 in the direction (direction -x) orthogonal to both the direction of the magnetization M1 (direction -y) and the direction of the heat current Q (direction +z). The anomalous Nernst effect causes each of the thermoelectric conversion elements 25 to generate an electromotive force E2 in the direction (direction +x) orthogonal to both the direction of the magnetization M2 (direction +y) and the direction of the heat current Q (direction +z).

As described above, since the thermoelectric conversion elements 24 and the thermoelectric conversion elements 25, which are arranged in parallel to one another, are electrically connected in series to one another, the electromotive force E1 generated in one thermoelectric conversion element 24 can be applied to the adjacent thermoelectric conversion element 25. Since the direction of the electromotive force E1 generated in one thermoelectric conversion element 24 is opposite to that of the electromotive force E2 generated in the adjacent thermoelectric conversion element 25, the electromotive force in the thermoelectric conversion element 24 and the electromotive force in the adjacent thermoelectric conversion element 25 are added up, thereby increasing an output voltage V.

As a modification of the thermoelectric conversion device 20 in FIG. 7, another configuration may be employed in which the plurality of thermoelectric conversion elements 24 and the plurality of thermoelectric conversion elements 25 are arranged such that the Nernst coefficient of the thermoelectric conversion element 24 is opposite in sign to that of the adjacent thermoelectric conversion element 25, and the plurality of thermoelectric conversion elements 24 and the plurality of thermoelectric conversion elements 25 share the same magnetization direction (that is, the magnetization M1 and the magnetization M2 have the same direction).

### Example 2

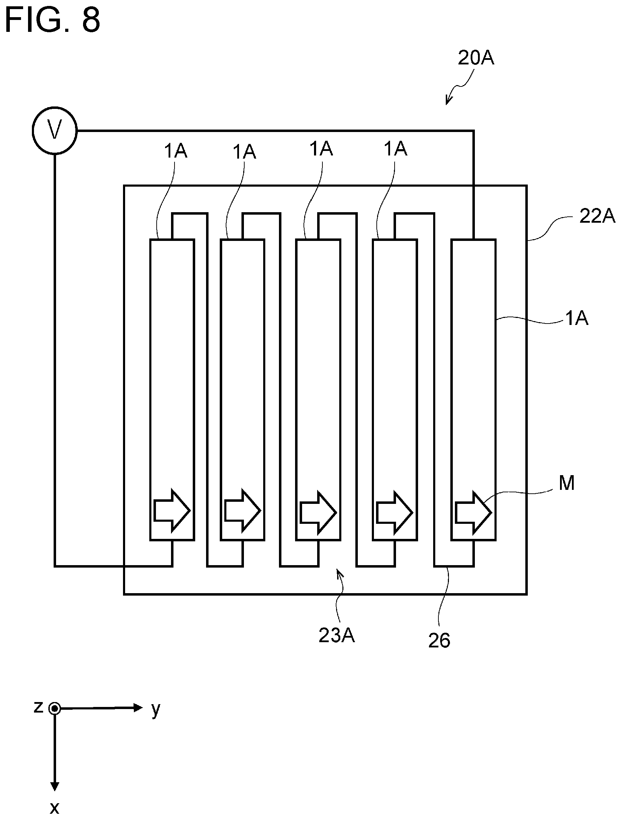

FIG. 8 is a plan view of a thermoelectric conversion device 20A according to Example 2 of the embodiments. The thermoelectric conversion device 20A includes, as a power generator 23A, a plurality of rectangular parallelepiped thermoelectric conversion elements 1A having Nernst coefficients with the same sign. Each of the thermoelectric conversion elements 1A is made of a material identical to that of the thermoelectric conversion element 1 shown in FIG. 2. The thermoelectric conversion elements 1A are arranged in parallel to one another on a substrate 22A in a direction (direction y) perpendicular to the longitudinal direction (direction x) such that they share the same direction of magnetization M (direction y), and the adjacent thermoelectric conversion elements 1A are connected via copper wiring 26 so that the thermoelectric conversion elements 1A are electrically connected in series. The heat current flows from the substrate 22A side toward the power generator 23A (in direction z). The thermoelectric conversion device 20A has a configuration in which the adjacent thermoelectric conversion elements 1A are connected via the copper wiring 26, and thus, can be easily manufactured as compared to the thermoelectric conversion device 20 of Example 1 shown in FIG. 7.

### Example 3

The thermoelectric mechanism using the anomalous Nernst effect allows the temperature gradient, the magnetization direction, and the direction of the electric voltage to be orthogonal to one another, which makes it possible to produce a thin sheet-shaped thermoelectric conversion element.

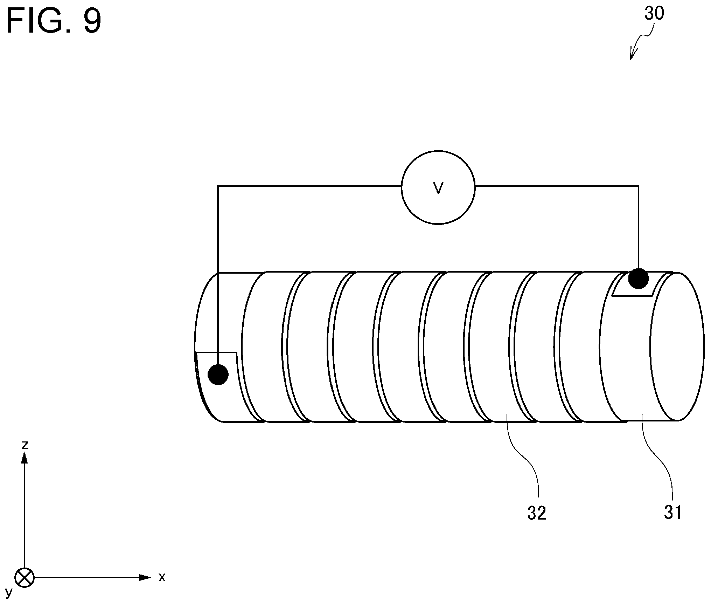

FIG. 9 shows an exterior configuration of a thermoelectric conversion device 30 according to Example 3 including a sheet-shaped thermoelectric conversion element 32. Specifically, the thermoelectric conversion device 30 includes a hollow member 31 and an elongated sheet-shaped (tape-shaped) thermoelectric conversion element 32 winding around the hollow member 31 to cover an outer surface of the hollow member 31. The thermoelectric conversion element 32 is made of a material identical to that of the thermoelectric conversion element 1 shown in FIG. 2. The magnetization direction of the thermoelectric conversion element 32 is parallel to a longitudinal direction (direction x) of the hollow member 31. When the heat current flows in a direction perpendicular to the longitudinal direction (direction x) of the hollow member 31 and a temperature gradient is created in a direction from the inside toward the outside of the hollow member 31, the anomalous Nernst effect generates an electric voltage V along a longitudinal direction of the elongated thermoelectric conversion element 32 (i.e., a direction perpendicular to both the magnetization direction and the direction of the heat current).

Instead of the elongated sheet-shaped thermoelectric conversion element 32 of the thermoelectric conversion device 30 of FIG. 9, a wire-rod thermoelectric conversion element may be wound around the hollow member 31.

Here, in FIG. 7 to FIG. 9, let the longitudinal length of the thermoelectric conversion element (s) be denoted by L, and the thickness (height) of the thermoelectric conversion element (s) be denoted by H. The electric voltage generated by the anomalous Nernst effect is proportional to L/H. That is, the longer and thinner the thermoelectric conversion element(s), the greater the generated electric voltage. Therefore, the anomalous Nernst effect is expected to be enhanced by employing a power generator having thermoelectric conversion elements which are electrically connected in series, or employing a wire-rod or an elongated sheet-shaped thermoelectric conversion element.

The thermoelectric conversion devices illustrated in Example 1 to Example 3 can be used for various applications. Especially, in a temperature range between room temperature and several hundred degrees Celsius, a self-sustaining power supply for an Internet of Things (IoT) sensor or a heat flux sensor is one possible application.

For example, by applying the thermoelectric conversion device of the embodiments to a heat flux sensor, it is possible to determine whether thermal insulation performance of a building is good or bad. By providing the thermoelectric conversion device in an exhaust device of a motor vehicle, it is possible to convert heat from exhaust gas (waste heat) into electricity, and to effectively use the thermoelectric conversion device as an auxiliary power supply. Further, by arranging heat flux sensors in a mesh-like pattern on a wall surface of a certain space, it is possible to perform space recognition of heat current or heat sources. This technique is expected to be applicable to, for example, a high-precision temperature control of high-density crop cultivation or livestock growth, or to a driver detection system for automatic driving. The heat flux sensors can also be used in room air conditioning management, or core body temperature management in medical treatment. In addition, the thermoelectric conversion element of the embodiments can be formed into powder or paste, thus offering promising applications in a wide range of fields.

The embodiments have focused on the electric voltage generated by the anomalous Nernst effect. In practice, the output voltage can be increased by virtue of synergy among the electric voltage generated by the Seebeck effect resulting from a temperature gradient, the Hall effect that occurs based on the electric voltage generated by the Seebeck effect, and the electric voltage generated by the anomalous Nernst effect.

As described above, according to the thermoelectric conversion element of the embodiments, alloy of Fe and Al which are large in Clarke number and inexpensive and non-toxic materials is capable of exhibiting the anomalous Nernst effect. In particular, by adopting the off-stoichiometric composition in which the composition ratio of Fe to Al is adjusted, or by adopting the polycrystal rather than the single crystal, it is possible to provide the thermoelectric conversion element having a Nernst coefficient insensitive to temperature change in a wide range of 200 K to 400 K. This eliminates the need to provide a temperature calibration circuit or a thermometer, which used to be required for heat flux sensors or other such devices made of materials whose Nernst coefficients are very sensitive to temperature change around room temperature. It is therefore possible to manufacture the thermoelectric conversion device at a low cost.

In FIG. 3 to FIG. 6, although the thermoelectric conversion element is made of the Fe-Al alloy, or the Fe-Al-V alloy obtained by substituting a part of Fe sites of the Fe-Al alloy by V, a transition element or a main-group element other than Al, or a transition element other than V can also be employed. That is, the following materials are expected to exhibit the anomalous Nernst effect: a first material with a stoichiometric composition of Fe₃X (where X is a main-group element or a transition element); a second material with an off-stoichiometric composition in which the composition ratio of Fe to X deviates from 3:1; a third material obtained by substituting a part of Fe sites in the first material or a part of Fe sites in the second material by a main-group metal element or a transition element other than X; a fourth material with a composition of Fe₃M1₁-ₓM2ₓ (0<x<1) where M1 and M2 are main-group elements different from each other; or a fifth material obtained by substituting a part of Fe sites in the first material by a transition element other than X and substituting a part of X sites in the first material by a main-group metal element other than X. Candidates for X other than Al include Ga, Ge, Sn, Si, Ti, Zr, Hf, V, Nb, Ta, Cr, Mo, W, Sc, Ni, Mn, or Co. Examples of a combination of M1 and M2 constituting the fourth material include a combination of Ga and Al, a combination of Si and Al, and a combination of Ga and B.

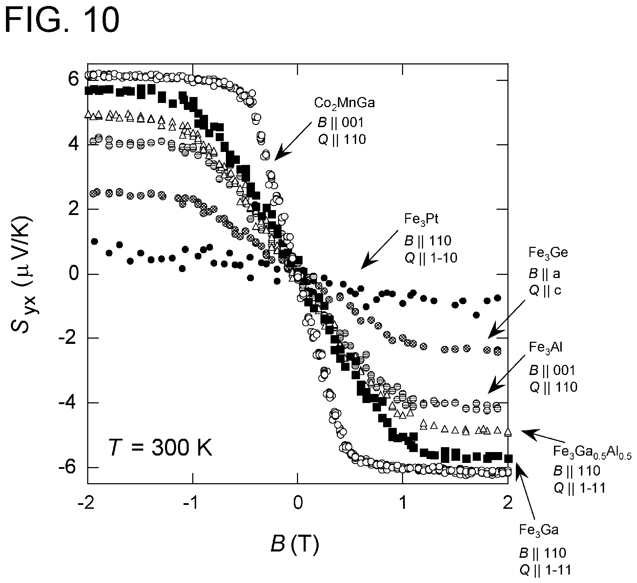

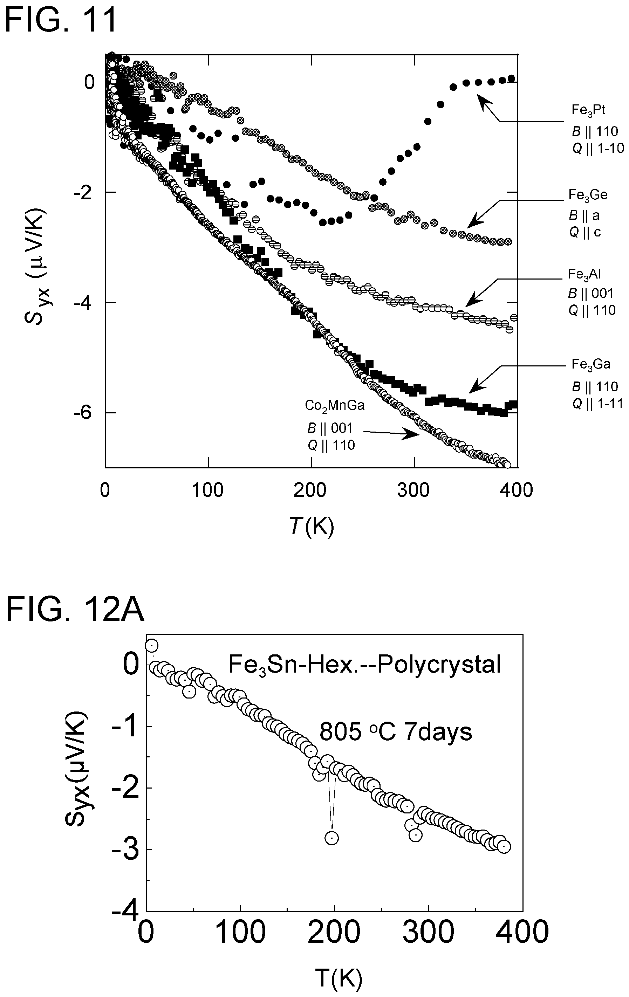

For example, the anomalous Nernst effect is also observed in Fe-Ge alloy, Fe-Ga alloy, and Fe-Ga-Al alloy. FIG. 10 shows magnetic field dependence of the Nernst coefficients (S_{yx}) at T=300 K for Fe₃Pt, Fe₃Ge, Fe₃Al, Fe₃Ga_{0.5}Al_{0.5}, Fe₃Ga, and Co₂MnGa. FIG. 11 shows the temperature dependence of the Nernst coefficients for Fe₃Pt, Fe₃Ge, Fe₃Al, Fe₃Ga, and Co₂MnGa.

In FIG. 10 and FIG. 11, a data set for Fe₃Ge represents observational results when the magnetic field B parallel to an a axis is applied to the thermoelectric conversion element 1 made of hexagonal single crystals of Fe₃Ge, and the heat current Q parallel to a c axis flows through the thermoelectric conversion element 1, a data set for Fe₃Al represents observational results when the magnetic field B parallel to [001] is applied to the thermoelectric conversion element 1 made of cubic single crystals of Fe₃Al, and the heat current Q parallel to [110] flows through the thermoelectric conversion element 1, and a data set for Fe₃Ga represents observational results when the magnetic field B parallel to [110] is applied to the thermoelectric conversion element 1 made of cubic single crystals of Fe₃Ga, and the heat current Q parallel to [1-11] flows through the thermoelectric conversion element 1. In FIG. 10, a data set for Fe₃Ga_{0.5}Al_{0.5} represents observational results when the magnetic field B parallel to [110] is applied to the thermoelectric conversion element 1 made of single crystals of Fe₃Ga_{0.5}Al_{0.5}, and the heat current Q parallel to [1-11] flows through the thermoelectric conversion element 1. In FIG. 10 and FIG. 11, a data set for Fe₃Pt represents observational results when the magnetic field B parallel to [110] is applied to the thermoelectric conversion element 1 made of single crystals of Fe₃Pt, and the heat current Q parallel to [1-10] flows through the thermoelectric conversion element 1, and a data set for Co₂MnGa represents observational results when the magnetic field B parallel to [001] is applied to the thermoelectric conversion element 1 made of single crystals of Co₂MnGa, and the heat current Q parallel to [110] flows through the thermoelectric conversion element 1.

FIG. 10 and FIG. 11 suggest that |S_{yx}| of the Fe₃Ge single crystals is smaller than that of the Fe₃Al single crystals, but is larger than that of the Fe₃Pt single crystals, and |S_{yx}| of the Fe₃Ge single crystals at room temperature exceeds 2.0 µV/K, reaching a practical level for use in thermoelectric conversion devices such as a heat flux sensor. Further, | S_{yx} | of the Fe₃Ga_{0.5}Al_{0.5} single crystals which are ternary compounds is larger than that of the Fe₃Al single crystals, reaching about 5.0 µV/K at room temperature. Further, | S_{yx} | of the Fe₃Ga single crystals at room temperature is well over 5.0 µV/K, approaching the record high value (6 µV/K) of the Co₂MnGa single crystals. Hexagonal single crystals of Fe₃Ga are also found to exhibit the anomalous Nernst effect.

FIG. 11 suggests that the Nernst coefficients of the single crystals of Fe₃Ge, Fe₃Al, and Fe₃Ga change slowly with temperature compared to the single crystals of Fe₃Pt and Co₂MnGa, in a temperature range of 200 K to 400 K.

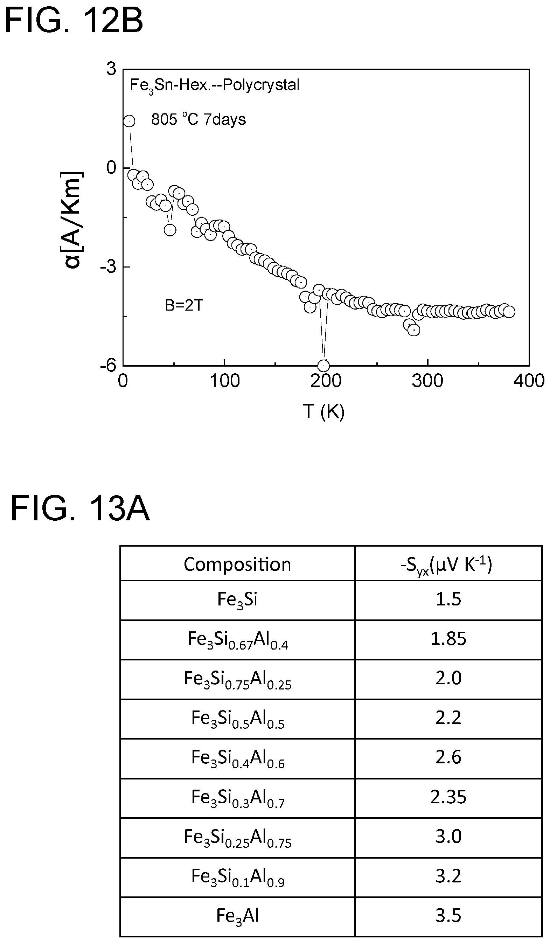

The anomalous Nernst effect is also observed in Fe-Sn alloy. FIG. 12A shows the temperature dependence of the Nernst coefficient of a hexagonal polycrystal of Fe₃Sn which is obtained by melting and synthesizing a polycrystal in an arc furnace, and then performing synthesizing through annealing at 805 degrees Celsius for one week. FIG. 12B shows the temperature dependence of transverse thermoelectric conductivity α[A/Km] at the magnetic field B=2T, which is estimated by the anomalous Nernst effect of Fe₃Sn. This experimental data suggests that the Nernst coefficient |S_{yx}| of the Fe₃Sn polycrystal increases to 3 µV/K or more at room temperature or more.

Next, reference will be made to measurement results of the anomalous Nernst effect after preparing mixed crystals between three polycrystals (Fe₃Si, Fe₃Al, and Fe₃Ga) .

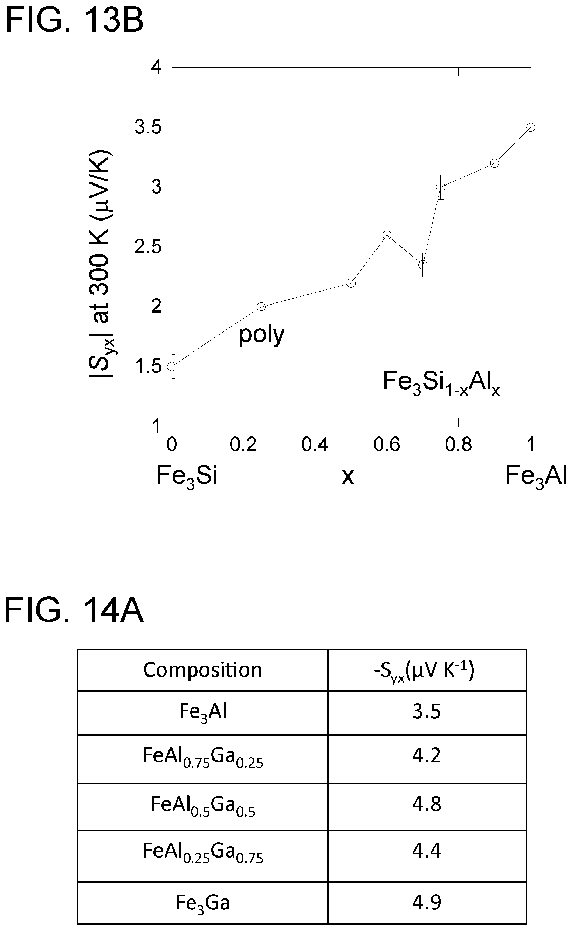

FIG. 13A and FIG. 13B show the Nernst coefficients of polycrystals of Fe₃Si₁₋ₓAlₓ (0≤x≤1) as mixed crystals of Fe₃Si and Fe₃Al, at T=300 K. Here, Fe₃Si_{0.67}Al_{0.4} shown in FIG. 13A is a soft magnetic material called Sendust. FIG. 13A and FIG. 13B suggest that the Nernst coefficient |S_{yx}| increases with an increase in the content of Al except for Fe₃Si_{0.3}Al_{0.7}.

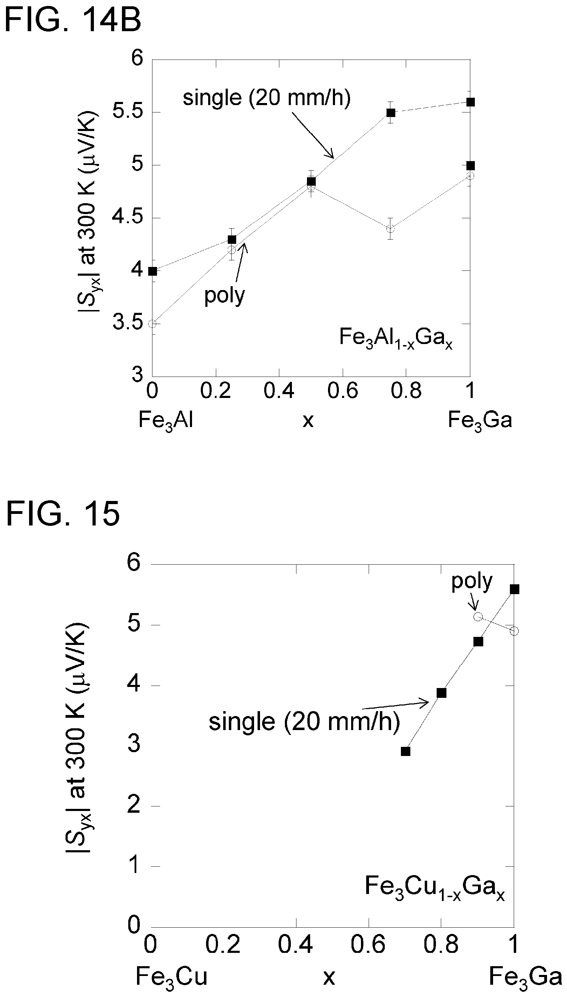

FIG. 14A and FIG. 14B show the Nernst coefficients of polycrystals of Fe₃Al₁₋ₓGaₓ (0≤x≤1) as mixed crystals of Fe₃Al and Fe₃Ga, at T=300 K. FIG. 14B also shows the Nernst coefficients of single crystals of Fe₃Al₁₋ₓGaₓ which are prepared at a crystal growth rate of 20 mm/h. FIG. 14A and FIG. 14B suggest that the Nernst coefficients |S_{yx}| of the single crystals are larger than those of the polycrystals, and in both the single crystals and the polycrystals, the Nernst coefficient |S_{yx}| increases with an increase in the content of Ga except for the Fe₃Al_{0.25}Ga_{0.75} polycrystal.

FIG. 15 shows the Nernst coefficients of single crystals and polycrystals of Fe₃Cu₁₋ₓGaₓ (0.6<x≤1) at T=300 K, obtained by substituting a part of Ga sites of Fe₃Ga by Cu. The single crystals of Fe₃Cu₁₋ₓGaₓ are also prepared at a crystal growth rate of 20 mm/h. FIG. 15 suggests that the Nernst coefficient | S_{yx} | of the Fe₃Cu₁₋ₓGaₓ single crystals decreases as the content of Cu increases and the content of Ga decreases, but exceeds 3 µV/K at x=0.7, reaching a practical level.

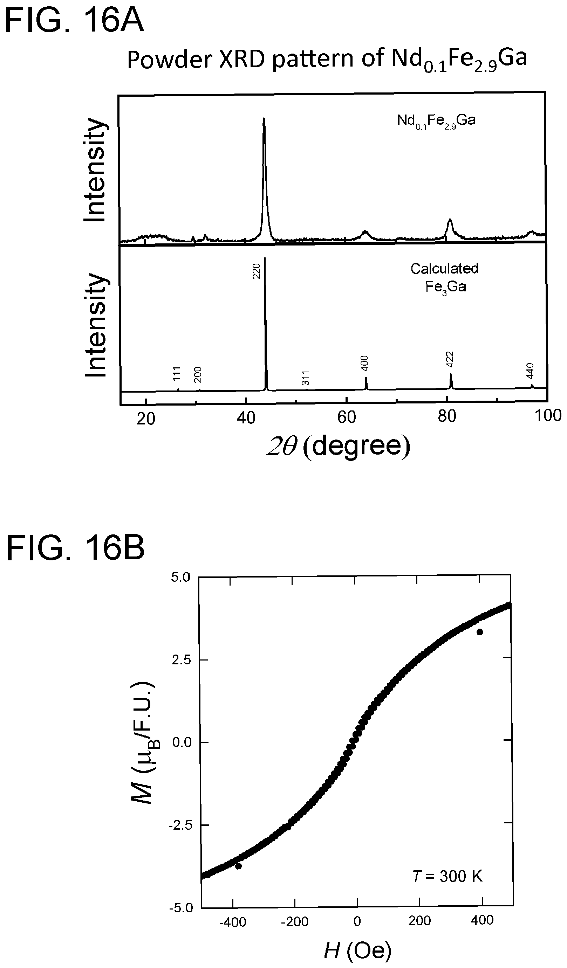

Next, experimental results after Fe₃Ga is doped with Nd, Ho, Y, or Tb will be described with reference to FIG. 16A to FIG. 20B.

FIG. 16A shows X-ray diffraction patterns of Nd_{0.1}Fe_{2.9}Ga and Fe₃Ga, and FIG. 16B shows magnetic field dependence of magnetization of Nd_{0.1}Fe_{2.9}Ga at T=300 K. FIG. 16A suggests that Nd_{0.1}Fe_{2.9}Ga and Fe₃Ga have nearly the same crystal structure. As shown in FIG. 16B, Nd_{0.1}Fe_{2.9}Ga has magnetization which reaches a saturation magnetization of 4.08 µ_{B}/F.U. at 39.8 kA/m (500 Oe), and has almost no coercivity.

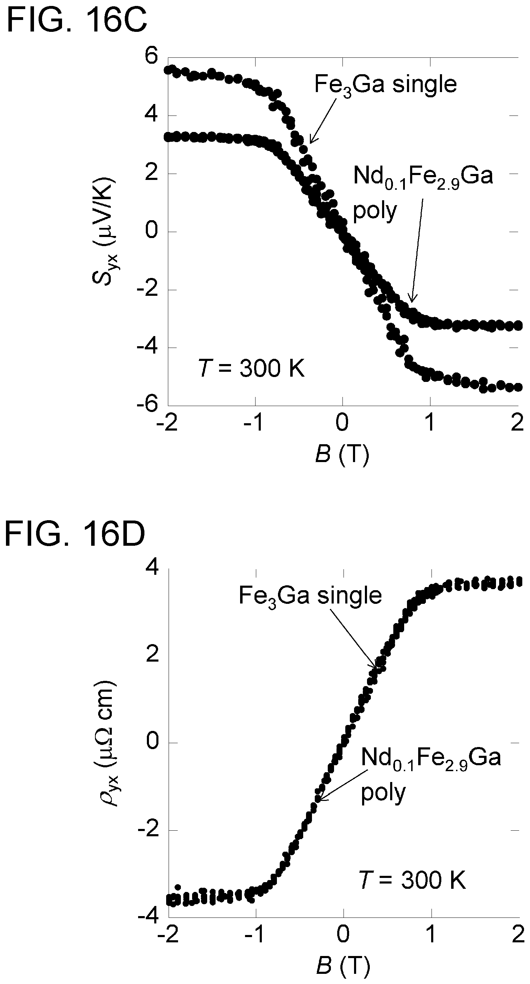

FIG. 16C shows magnetic field dependence of the Nernst coefficients at T=300 K for a single crystal of Fe₃Ga and a polycrystal of Nd_{0.1}Fe_{2.9}Ga. FIG. 16D shows magnetic field dependence of Hall resistivity at T=300 K for the single crystal of Fe₃Ga and the polycrystal of Nd_{0.1}Fe_{2.9}Ga. FIG. 16C suggests that the Nernst coefficient | S_{yx} | of the Nd_{0.1}Fe_{2.9}Ga polycrystal is smaller than that of the Fe₃Ga single crystal, but exceeds 3 µV/K, reaching a practical level. FIG. 16D suggests that the magnetic field dependence of the Hall resistivity ρ_{yx} of the Fe₃Ga single crystal shows nearly the same behavior as that of the Nd_{0.1}Fe_{2.9}Ga polycrystal.

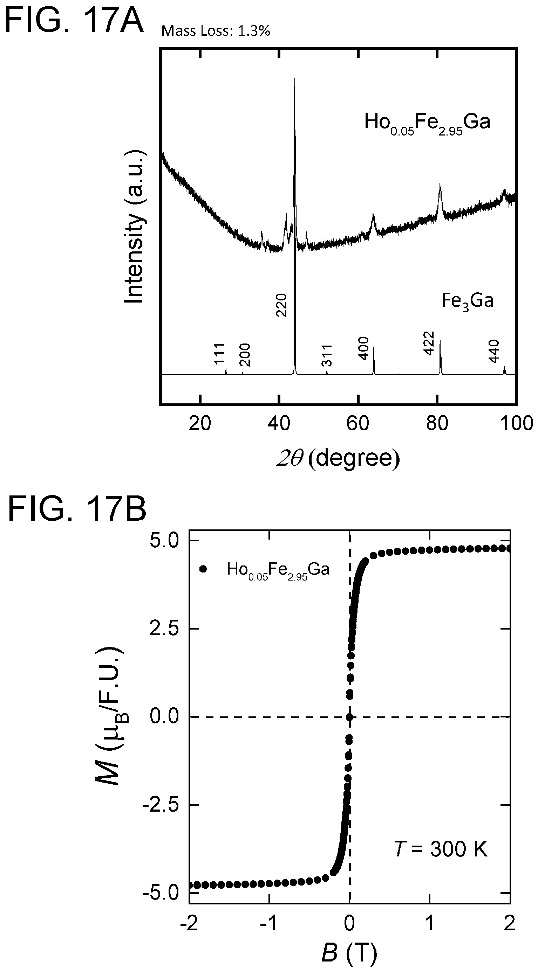

FIG. 17A shows X-ray diffraction patterns of Ho_{0.05}Fe_{2.95}Ga and Fe₃Ga, and FIG. 17B shows magnetic field dependence of magnetization of Ho_{0.05}Fe_{2.95}Ga at T=300 K. FIG. 17A suggests that Ho_{0.05}Fe_{2.95}Ga and Fe₃Ga have nearly the same crystal structure. As shown in FIG. 17B, Ho_{0.05}Fe_{2.95}Ga has magnetization which reaches a saturation magnetization of 4.8 µ_{B}/F.U. at 2T, and has almost no coercivity.

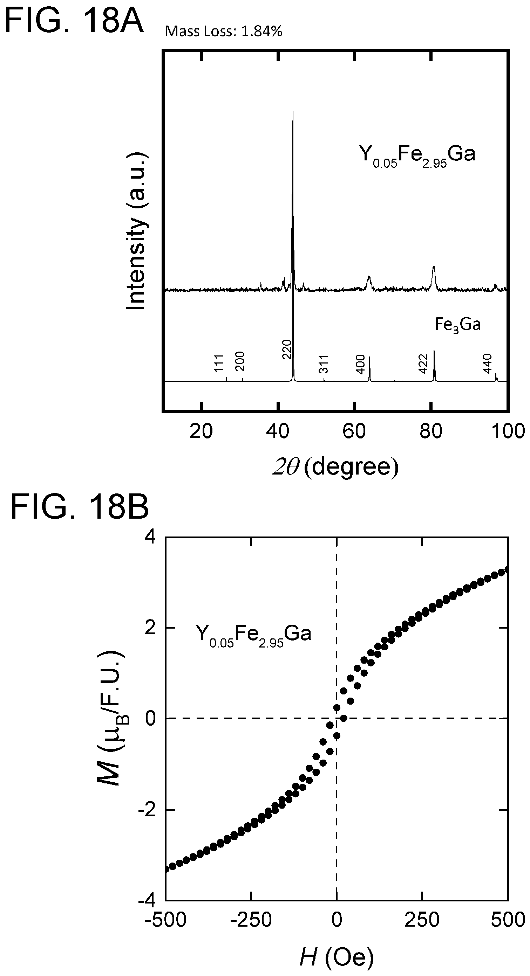

FIG. 18A shows X-ray diffraction patterns of Y_{0.05}Fe_{2.95}Ga and Fe₃Ga, and FIG. 18B shows magnetic field dependence of magnetization of Y_{0.05}Fe_{2.95}Ga. FIG. 18A suggests that Y_{0.05}Fe_{2.95}Ga and Fe₃Ga have nearly the same crystal structure. FIG. 18B suggests that Y_{0.05}Fe_{2.95}Ga has magnetization which reaches a saturation magnetization of 3.28 µ_{B}/F.U. at 39.8 kA/m (500 Oe), and has a coercivity of about 1.6 kA/m (20 Oe).

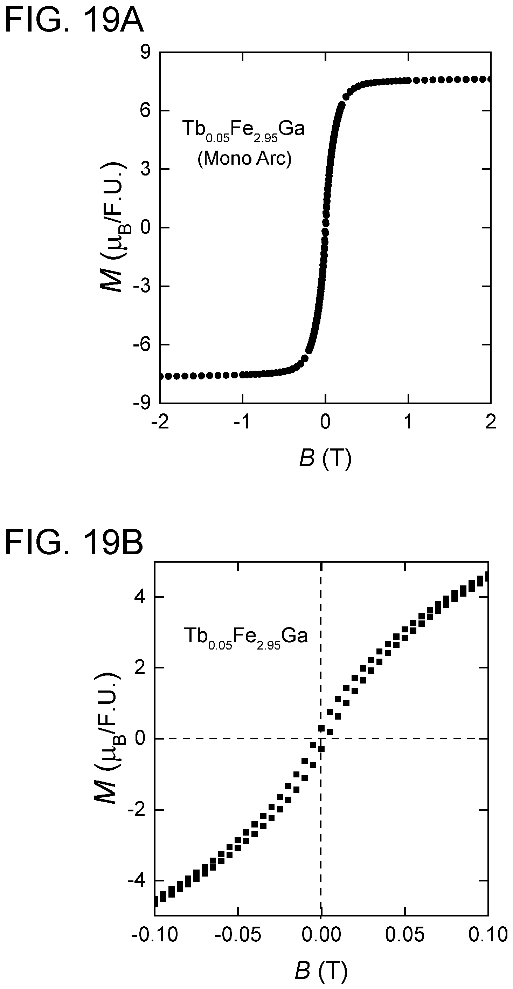

FIG. 19A shows magnetic field dependence of magnetization of Tb_{0.05}Fe_{2.95}Ga prepared by using a mono arc furnace, and FIG. 19B is a graph illustrating an enlarged view in a low magnetic field region of FIG. 19A. FIG. 19A and FIG. 19B suggest that Tb_{0.05}Fe_{2.95}Ga has magnetization which reaches a saturation magnetization of 7.5 µ_{B}/F.U. at 2T, and has a coercivity of about 3.2 kA/m (40 Oe).

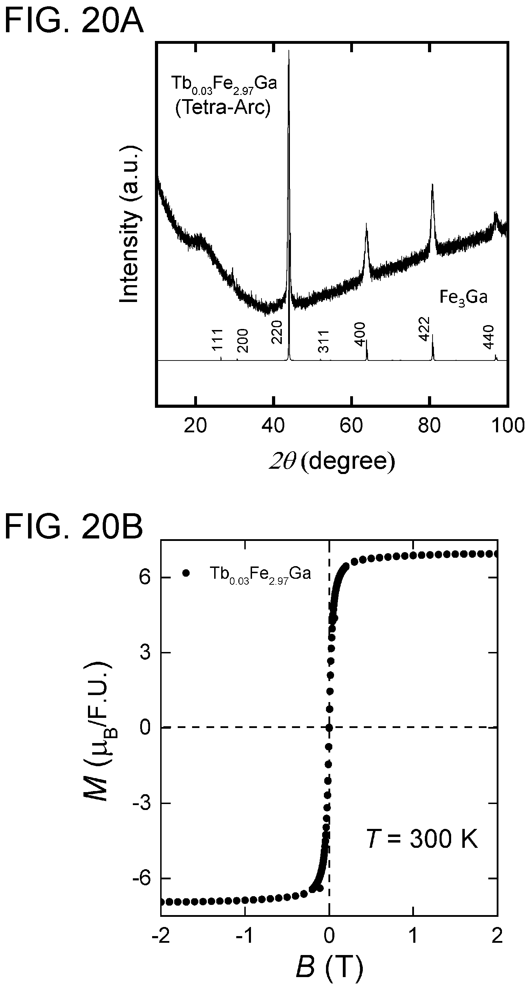

FIG. 20A shows an X-ray diffraction pattern of Tb_{0.03}Fe_{2.97}Ga prepared by using a tetra arc furnace and an X-ray diffraction pattern of Fe₃Ga, and FIG. 20B shows magnetic field dependence of magnetization of Tb_{0.03}Fe_{2.97}Ga at T=300 K. FIG. 20A suggests that Tb_{0.03}Fe_{2.97}Ga and Fe₃Ga have nearly the same crystal structure. As shown in FIG. 20B, Tb_{0.03}Fe_{2.97}Ga has magnetization which reaches a saturation magnetization of 6.9 µ_{B}/F.U. at 2T, and has almost no coercivity.

Although FIG. 16A to FIG. 17B and FIG. 19A to FIG. 20B show the anomalous Nernst effect in the materials (the third materials) obtained by substituting a part of Fe sites of Fe₃Ga by Nd, Ho, or Tb, other third materials obtained through substitution by other lanthanoids (such as Gd) are also expected to exhibit the anomalous Nernst effect.

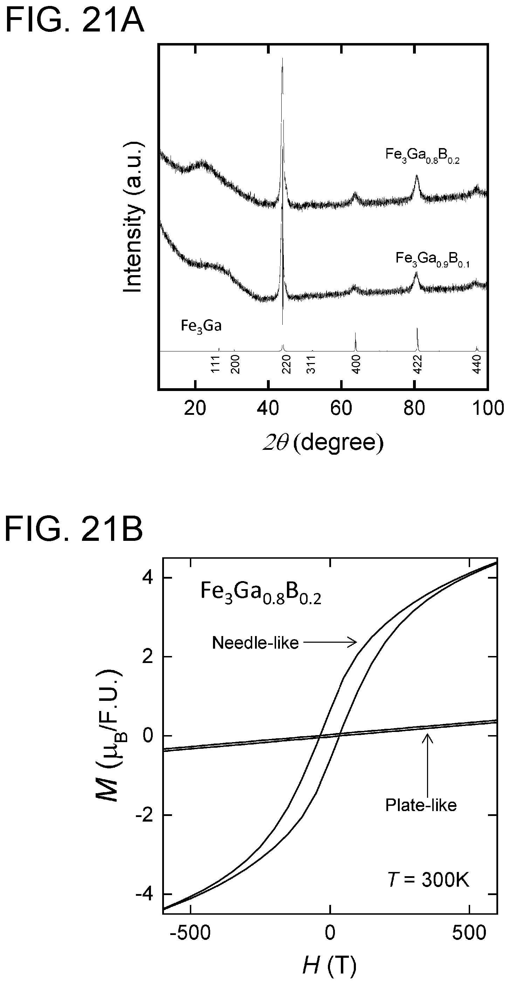

Next, experimental results after Fe₃Ga is doped with B, Mn, or Pt will be described with reference to FIG. 21A to FIG. 23B.

First, reference will be made to the experimental results after Fe₃Ga is doped with B. FIG. 21A shows X-ray diffraction patterns of Fe₃Ga_{0.8}B_{0.2}, Fe₃Ga_{0.9}B_{0.1}, and Fe₃Ga. This indicates that Fe₃Ga_{0.8}B_{0.2} and Fe₃Ga_{0.9}B_{0.1} have nearly the same crystal structure as that of Fe₃Ga. Furthermore, energy-dispersive X-ray spectroscopy (EDX) (not shown) suggests that the dopant B appears near the boundary of Fe₃Ga.

FIG. 21B shows magnetic field dependence of magnetization at T=300 K for a needle-like sample and a plate-like sample, both of which are made of Fe₃Ga_{0.8}B_{0.2}. The needle-like sample (columnar sample) shown in FIG. 21B is magnetized in a longitudinal direction of the needle-like sample, and a magnetic field is applied in parallel to the longitudinal direction. The plate-like sample shown in FIG. 21B is magnetized in an in-plane direction of the plate-like sample, and a magnetic field is applied in an out-of-plane direction of the plate-like sample. As just described, in the plate-like sample, since the magnetization direction is perpendicular to the magnetic field direction, it is necessary to apply a strong magnetic field in order to align the magnetization with the magnetic field direction. FIG. 21B suggests that as for the plate-like sample, the magnetization only slightly linearly changes when the strong magnetic field is applied, whereas as for the needle-like sample having magnetization in the direction parallel to the magnetic field, the magnetization largely changes, and a clear hysteresis loop is observed.

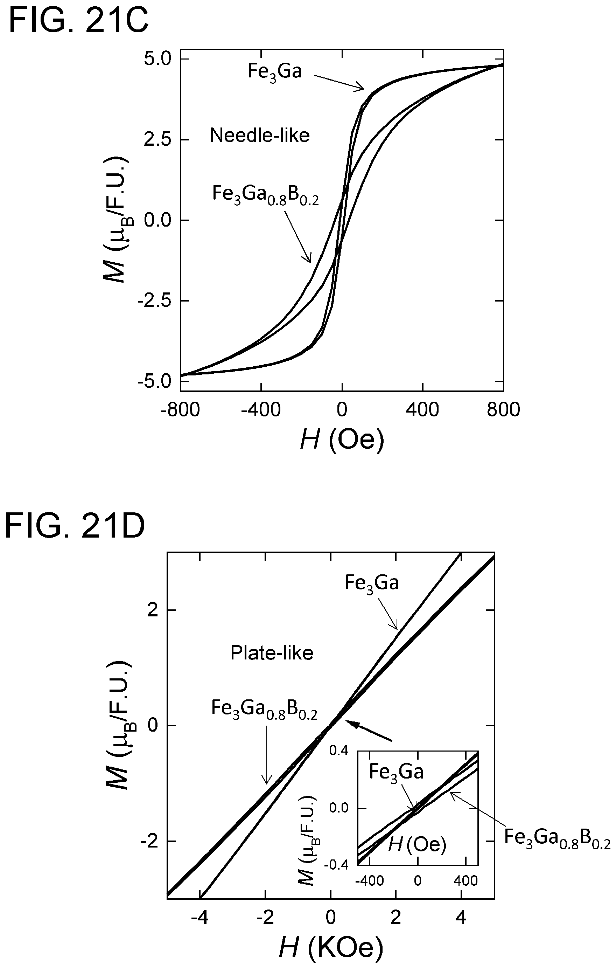

FIG. 21C shows magnetic field dependence of magnetization of needle-like samples of Fe₃Ga_{0.8}B_{0.2} and Fe₃Ga. The needle-like samples shown in FIG. 21C are magnetized in the longitudinal direction, and a magnetic field is applied in parallel to the magnetization direction. Since the magnetization direction is parallel to the magnetic field direction, the magnetization of Fe₃Ga and the magnetization of Fe₃Ga_{0.8}B_{0.2} are saturated at relatively weak magnetic fields (about 31.8 kA/m (400 Oe) and about 63.7 kA/m (800 Oe), respectively). As shown in FIG. 21C, a clearer hysteresis loop is observed for Fe₃Ga_{0.8}B_{0.2} than Fe₃Ga, and a coercivity of Fe₃Ga is about 796 A/m (10 Oe), whereas a coercivity of Fe₃Ga_{0.8}B_{0.2} is about 2.8 kA/m (35 Oe).

FIG. 21D shows magnetic field dependence of magnetization of plate-like samples of Fe₃Ga_{0.8}B_{0.2} and Fe₃Ga. The plate-like samples shown in FIG. 21D are magnetized in the in-plane direction, and a magnetic field is applied in the out-of-plane direction. Since the magnetization direction is perpendicular to the magnetic field direction, a strong magnetic field is required to align the magnetization with the out-of-plane direction. As for both Fe₃Ga and Fe₃Ga_{0.8}B_{0.2}, the magnetization linearly increases until the magnetic field exceeds 238.7 kA/m (3 kOe), and the hysteresis is weak. In fact, almost no coercivity is observed for Fe₃Ga. In contrast, the enlarged view in a low magnetic field region (inset of FIG. 21D) suggests that Fe₃Ga_{0.8}B_{0.2} has a coercivity of about 2.8 kA/m (35 Oe).

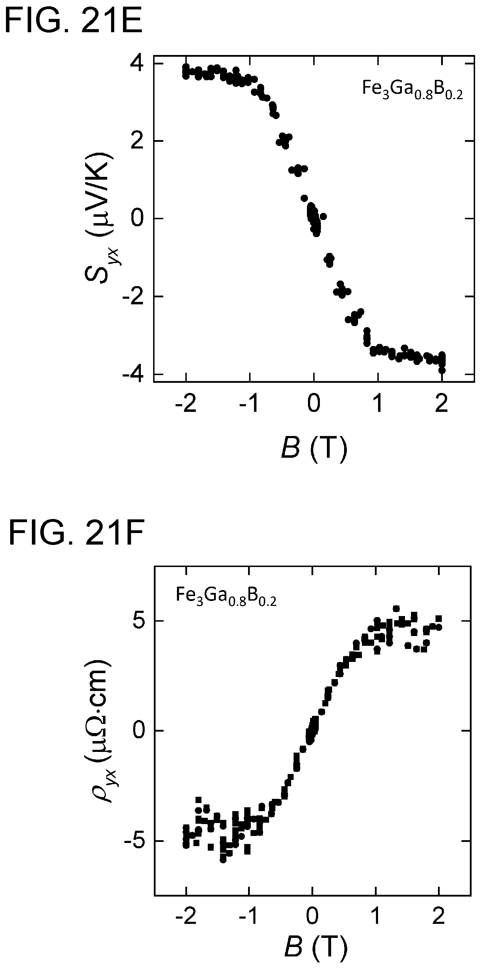

FIG. 21E shows magnetic field dependence of a Nernst coefficient of a plate-like sample of Fe₃Ga_{0.8}B_{0.2}, and FIG. 21F shows magnetic field dependence of Hall resistivity of the plate-like sample of Fe₃Ga_{0.8}B_{0.2}. The plate-like sample shown in FIG. 21E and FIG. 21F is magnetized in the in-plane direction, and a magnetic field is applied in the out-of-plane direction, similarly to that in FIG. 21D. In FIG. 21F, data points when the magnetic field increases from -2 T to +2 T are indicated by circles, and data points when the magnetic field decreases from +2 T to -2 T are indicated by squares. FIG. 21E suggests that the Nernst coefficient | S_{yx} | of Fe₃Ga_{0.8}B_{0.2} reaches 4µV/K, which is about 80% of the Nernst coefficient of the Fe₃Ga polycrystal (4.9 µV/K : see FIG. 14A and FIG. 14B) .

As described above, by substituting a part of Ga sites of Fe₃Ga by B, it is possible to increase the coercivity and to secure about 80% of the Nernst coefficient of Fe₃Ga. Thus, it can be said that Fe₃Ga_{0.8}B_{0.2} is advantageous in manufacturing thermopiles that can work under zero magnetic field.

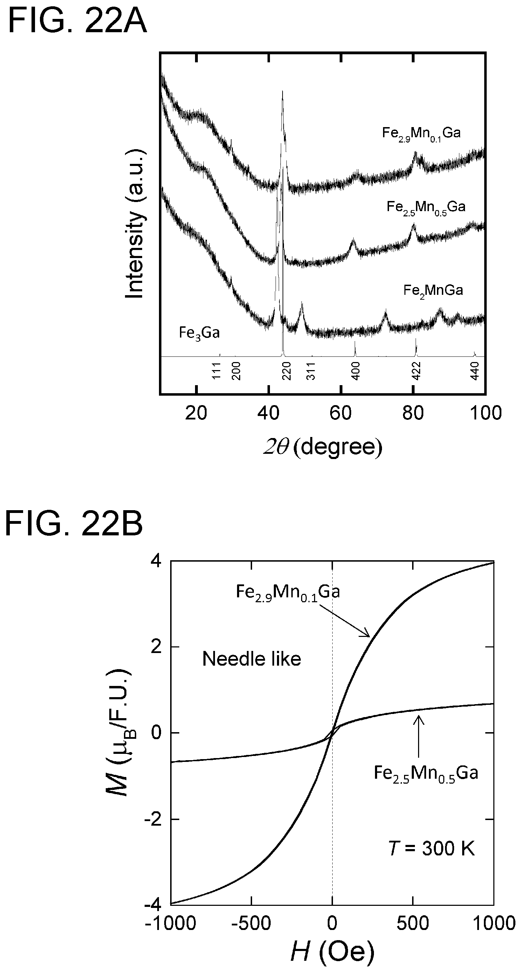

Next, reference will be made to the experimental results after Fe₃Ga is doped with Mn. FIG. 22A shows X-ray diffraction patterns of Fe_{2.9}Mn_{0.1}Ga, Fe_{2.5}Mn_{0.5}Ga, Fe₂MnGa, and Fe₃Ga, and FIG. 22B shows magnetic field dependence of magnetization at T=300 K for needle-like samples of Fe_{2.9}Mn_{0.1}Ga and Fe_{2.5}Mn_{0.5}Ga. The needle-like samples shown in FIG. 22B are magnetized in the longitudinal direction, and a magnetic field is applied in parallel to the magnetization direction.

FIG. 22A suggests that Fe_{2.9}Mn_{0.1}Ga and Fe_{2.5}Mn_{0.5}Ga have nearly the same crystal structure as that of Fe₃Ga. As shown in FIG. 22B, Fe_{2.9}Mn_{0.1}Ga has a large magnetization, but shows almost no hysteresis. In contrast, Fe_{2.5}Mn_{0.5}Ga shows a small hysteresis and has a coercivity of about 796 A/m (10 Oe) (which is the same coercivity as that of the needle-like sample of Fe₃Ga shown in FIG. 21C), but the magnetization is found to be considerably small as compared to Fe_{2.9}Mn_{0.1}Ga.

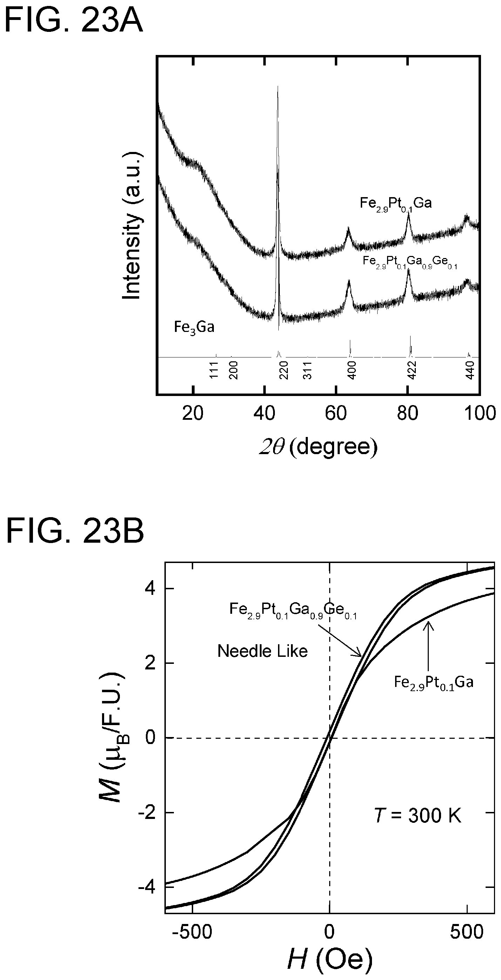

Next, reference will be made to the experimental results after Fe₃Ga is doped with Pt. FIG. 23A shows X-ray diffraction patterns of Fe_{2.9}Pt_{0.1}Ga, Fe_{2.9}Pt_{0.1}Ga_{0.9}Ge_{0.1}, and Fe₃Ga, and FIG. 23B shows magnetic field dependence of magnetization at T=300 K for needle-like samples of Fe_{2.9}Pt_{0.1}Ga and Fe_{2.9}Pt_{0.1}Ga_{0.9}Ge_{0.1}. The needle-like samples shown in FIG. 23B are magnetized in the longitudinal direction, and a magnetic field is applied in parallel to the magnetization direction.

FIG. 23A suggests that Fe_{2.9}Pt_{0.1}Ga and Fe_{2.9}Pt_{0.1}Ga_{0.9}Ge_{0.1} have nearly the same crystal structure as that of Fe₃Ga. As shown in FIG. 23B, Fe_{2.9}Pt_{0.1}Ga shows almost no hysteresis. In contrast, Fe_{2.9}Pt_{0.1}Ga_{0.9}Ge_{0.1} shows a small hysteresis and has a coercivity of about 637 A/m (8 Oe). This indicates that a coercivity is increased by substituting a part of Ga sites of Fe_{2.9}Pt_{0.1}Ga by Ge.

As described above, since the increase in coercivity can also be found when a part of Ga sites of Fe₃Ga is substituted by B (see FIG. 21C and FIG. 21D), the substitution of Ga sites is believed to affect magnetic properties.

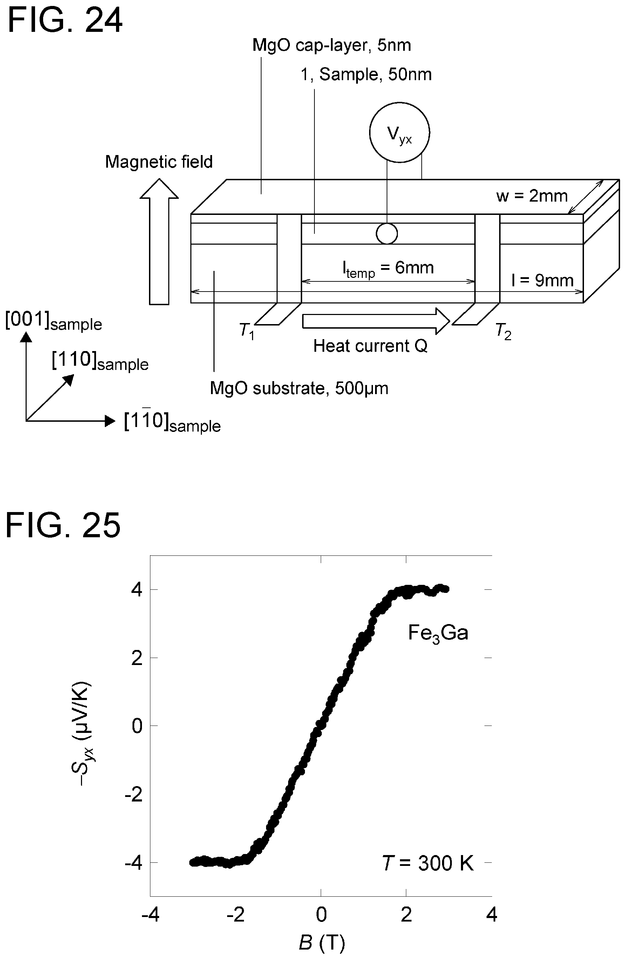

The thermoelectric conversion element 1 can be implemented as a thin film. Such embodiments will be described next with reference to FIG. 24 to FIG. 30. In the following embodiments, the thermoelectric conversion element 1 is made of a first material with a composition of Fe₃X or a second material with an off-stoichiometric composition in which the composition ratio of Fe to X deviates from the first material, but is not limited thereto.

First, a method of producing a thin film will be described. In the example below, the thin film is produced by a sputtering method, but the method of producing the thin film is not limited. For example, a molecular beam epitaxy (MBE) method, a chemical vapor deposition (CVD), a pulsed laser deposition (PLD), a plating method, or other such methods may be adopted.

For example, the method of producing a Fe₃Ga thin film includes, first, using a DC magnetron sputtering apparatus to discharge a target with a composition ratio of Fe to Ga being 3:1 at room temperature, and preparing a thin film of Ga-doped Fe on a [001]-oriented magnesium oxide (MgO) substrate. The Fe₃Ga sample grown at room temperature is a polycrystalline thin film, but a [001]-oriented epitaxial thin film can be produced by performing annealing for 30 minutes at 500 °C without breaking vacuum after the film growth. As just described, the Fe₃Ga thin film is a [001]-oriented epitaxial thin film on the [001]-oriented MgO substrate.

An oxidation resistant layer made of MgO is provided on an outermost surface of the thin film. In addition to MgO, a typical cap layer made of Al, Al₂O₃, SiO₂ or the like may be employed as the oxidation resistant layer in order to prevent oxidation. A buffer layer between the thin film and the substrate, or the cap layer on the outermost surface of the thin film is not always necessary.

In the above-described production method using the sputtering apparatus, a T/S distance (which is a distance between the target and the substrate) is preferably in a range of 15 cm to 20 cm. Considering various production methods, the T/S distance may fall within a range of 5 cm to 40 cm.

A ferromagnetic material is difficult to align its magnetization in a direction perpendicular to a temperature difference due to a demagnetizing field, which makes it difficult to generate an electric voltage at zero magnetic field. However, by producing the thin film as described above, the contribution of the demagnetizing field increases in the out-of-plane direction of the thin film, whereas the effect of the demagnetizing field decreases to almost zero in the in-plane direction. This stabilizes the magnetization in the in-plane direction.

Next, a method of measuring the anomalous Nernst effect when a temperature gradient is applied in the in-plane direction to a thin film sample as the thermoelectric conversion element 1 will be described with reference to FIG. 24. In order to measure such an anomalous Nernst effect, for example, a rectangular parallelepiped structure is used as shown in FIG. 24. In the structure of FIG. 24, a thin film (Fe₃X thin film) sample with a thickness of 50 nm is stacked on an MgO substrate with a thickness of 500 µm, and an MgO cap layer with a thickness of 5 nm is stacked on the thin film sample. The structure has a longitudinal length of 9 mm and a lateral width of 2 mm. The thin film sample is provided with thermocouples in the longitudinal direction, and the distance between the thermocouples is 6 mm.

As described above, the thin film sample is magnetized in the in-plane direction. As shown in FIG. 24, when a magnetic field is applied to the thin film sample in the out-of-plane direction, the magnetization is aligned with the out-of-plane direction. When a heat current Q flows through the thin film sample in the longitudinal direction, a temperature difference ΔT (=T₂-T₁) occurs. As a result, in the same manner as in FIG. 2, the anomalous Nernst effect generates an electromotive force V_{yx} in a direction orthogonal to both the direction of the heat current Q and the magnetization direction (out-of-plane direction).

FIG. 25 shows the measurement results of the anomalous Nernst effect (magnetic field dependence of a Nernst coefficient at T=300 K) when the thin film sample shown in FIG. 24 is made of Fe₃Ga. FIG. 25 suggests that the Nernst coefficient |S_{yx}| of Fe₃Ga reaches 4.0 µV/K.

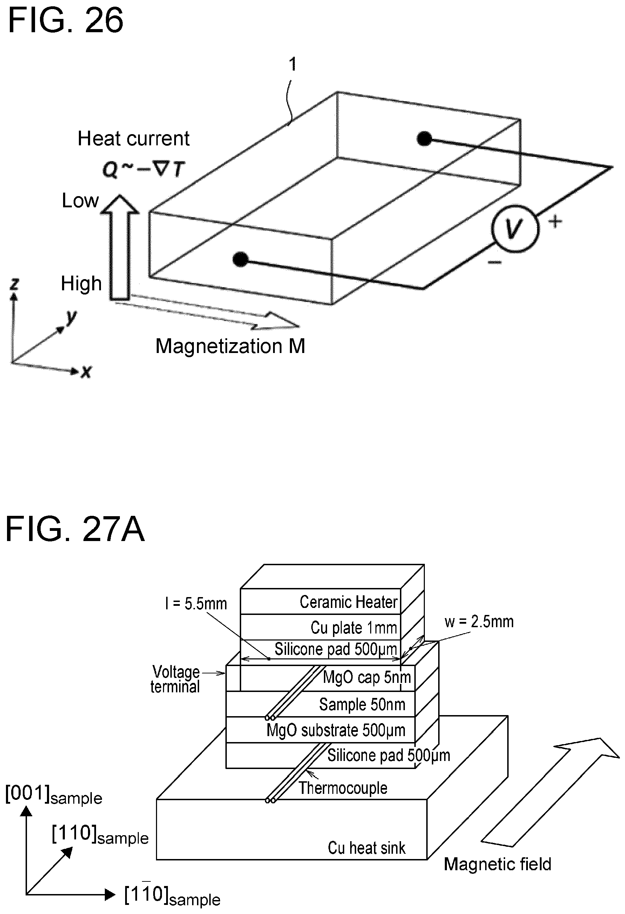

Although FIG. 24 and FIG. 25 show an example in which the temperature gradient is applied to the thin film sample in the in-plane direction, the anomalous Nernst effect can also occur when a temperature gradient is applied to the thin film sample in the out-of-plane direction as shown in FIG. 26. That is, the thin film sample as the thermoelectric conversion element 1 is magnetized in the in-plane direction (direction x), and when a heat current Q flows through the thin film sample in the out-of-plane direction (direction z), an electromotive force V is generated in a direction (direction y) orthogonal to both the direction of the heat current Q and the direction of the magnetization M.

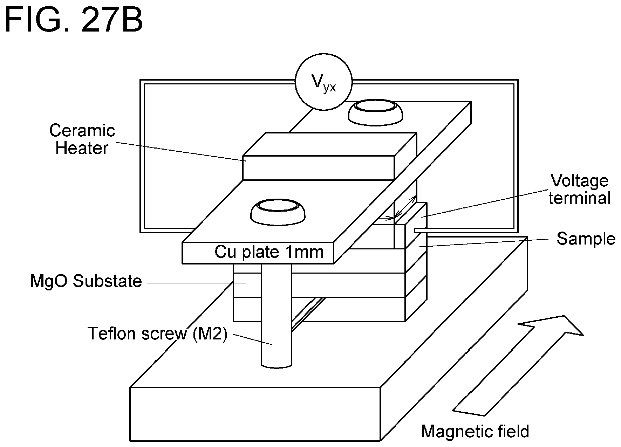

In order to measure such an anomalous Nernst effect, for example, a structure shown in FIG. 27A is used. In the structure of FIG. 27A, a silicone pad with a thickness of 500 µm is provided on a heat sink made of Cu, an MgO substrate with a thickness of 500 µm is stacked on the silicone pad, a thin film sample with a thickness of 50 nm is stacked on the MgO substrate, and an MgO cap layer with a thickness of 5 nm is stacked on the thin film sample. Voltage terminals are provided at both ends of the MgO cap layer in the longitudinal direction, and these voltage terminals are connected to both end portions of the thin film sample in the longitudinal direction. With this structure, as shown in FIG. 27B, it is possible to measure an electromotive force V_{yx} generated in the longitudinal direction of the thin film sample due to the anomalous Nernst effect.

A silicone pad with a thickness of 500 µm is stacked on the MgO cap layer, a copper plate with a thickness of 1 mm is stacked on the silicone pad, and a resistance heater (ceramic heater) is provided on the copper plate. Thermocouples are provided on an upper end of the MgO cap layer and a lower end of the MgO substrate. A heat current from the ceramic heater flows through the thin film sample from the upper end of the MgO cap layer to the lower end of the MgO substrate, and creates a temperature gradient ΔTₐₗₗ. Using the thermocouples, it is possible to measure the temperature gradient ΔTₐₗₗ in the out-of-plane direction [00-1]. In FIG. 27A and FIG. 27B, the magnetization direction of the thin film sample is parallel to the direction [110] of the applied magnetic field.

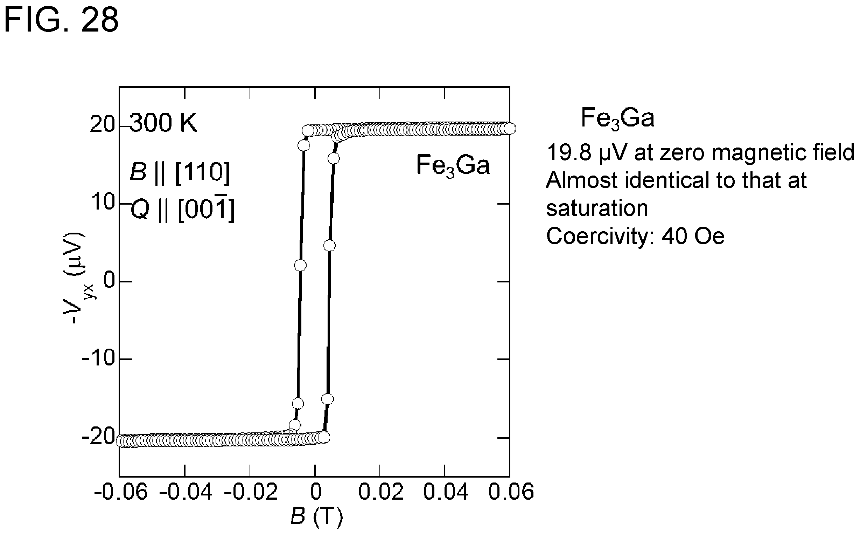

FIG. 28 shows the measurement results of the anomalous Nernst effect (magnetic field dependence of an electromotive force) at 300 K when the thin film sample shown in FIG. 27A and FIG. 27B is made of Fe₃Ga. FIG. 28 suggests that unlike in a bulk sample, in the thin film sample of Fe₃Ga, an electromotive force of 19.8 µV is obtained even at zero magnetic field, which is almost the same as a value at a saturation magnetic field. The coercivity of the thin film sample of Fe₃Ga is about 3.2 kA/m (40 Oe).

In this measurement, the temperature difference in the out-of-plane direction obtained by the thermocouples is ΔTₐₗₗ=1.5 K. Here, it is difficult to accurately estimate a temperature gradient ∇T_{film} of the thin film sample itself. Hence, the measurement results shown in FIG. 25 are used, which are obtained when the temperature gradient is applied in the in-plane direction of the thin film sample and the magnetic field is applied in the out-of-plane direction. Assuming that the Nernst coefficient (4.0 µV/K) of Fe₃Ga shown in FIG. 25 is used to calculate ∇T_{film} in the out-of-plane direction, the temperature gradient applied in the out-of-plane direction of the 50 nm-thin film sample of Fe₃Ga can be estimated to be 0.9 K/mm.

In the method of producing the thin film described above, annealing is performed after the film growth at room temperature. As described below, polycrystalline or amorphous thin films obtained after the film growth at room temperature without annealing can also exhibit the anomalous Nernst effect as much as the annealed thin film sample.

The non-annealed thin film can be produced easily, and can be used for a flexible film. The [001]-oriented MgO substrate is required for producing the epitaxial film described above. In contrast, any substrate can be used for producing the polycrystalline films or the amorphous films.

In addition to MgO, examples of substrate materials include, but are not limited to, Si, Al₂O₃, PET, and polyimide.

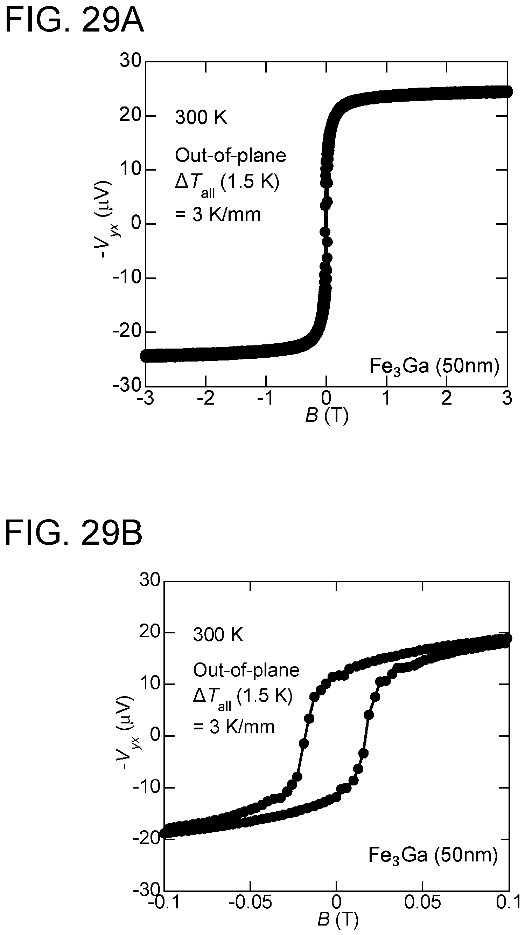

FIG. 29A shows measurement results of the anomalous Nernst effect (magnetic field dependence of an electromotive force) at T=300 K when as shown in FIG. 26, a temperature gradient is applied, in the out-of-plane direction, to the Fe₃Ga thin film sample grown on the MgO substrate without annealing after film growth at room temperature. FIG. 29B is a graph illustrating an enlarged view in a low magnetic field region of FIG. 29A. As is the case with FIG. 27A and FIG. 27B, in FIG. 29A and FIG. 29B, the thickness of the Fe₃Ga thin film sample is 50 nm, and the temperature gradient in the out-of-plane direction obtained by the thermocouples is ΔTₐₗₗ=1.5 K (3 K/mm) .

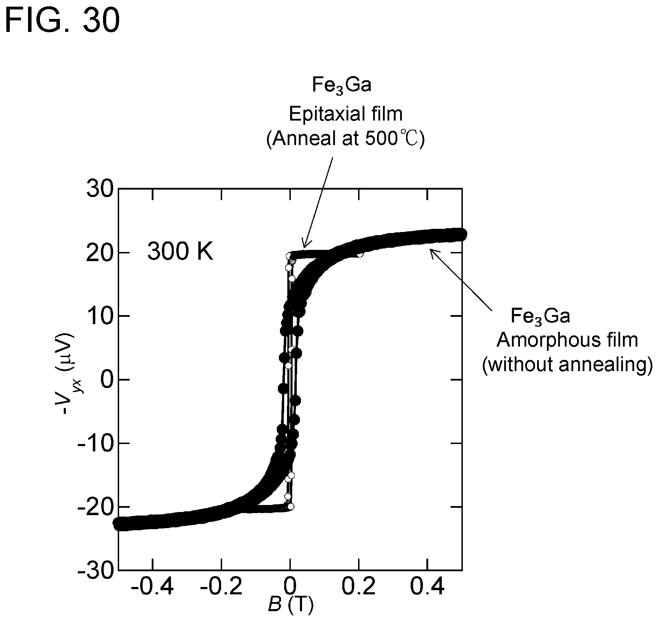

FIG. 30 shows the measurement results of the anomalous Nernst effect (magnetic field dependence of an electromotive force) when a temperature gradient is applied in the out-of-plane direction, to a Fe₃Ga epitaxial film obtained through annealing after the film growth at room temperature, and to a Fe₃Ga amorphous film obtained without annealing after the film growth at room temperature. The measurement result of the amorphous film in FIG. 30 corresponds to the measurement result shown in FIG. 29A and FIG. 29B, and the measurement result of the epitaxial film in FIG. 30 corresponds to the measurement result of Fe₃Ga shown in FIG. 28.

FIG. 29A, FIG. 29B and FIG. 30 suggest that the electromotive force of the amorphous film is almost the same as that of the epitaxial film under a high magnetic field, and is about half of the electromotive force of the epitaxial film at zero magnetic field. That is, a Nernst coefficient of the amorphous thin film sample of Fe₃Ga produced by film growth at room temperature is about 2 µV/K at zero magnetic field.

In the embodiments described above (FIG. 24 to FIG. 30), the thickness of the thin film is 50 nm, but the thickness of the thin film is not limited, and may be 10 µm or less, more preferably 1 µm or less.

As described above, according to the embodiments of FIG. 24 to FIG. 30, the thin film made of Fe₃Ga is used as the thermoelectric conversion element 1, indicating that the anomalous Nernst effect can be observed in inexpensive materials. Such a thin-film thermoelectric conversion element 1 is capable of exhibiting a huge anomalous Nernst effect even at zero magnetic field. Furthermore, the anomalous Nernst effect can be observed regardless of whether the thermoelectric conversion element 1 is a single crystal, a polycrystal, or amorphous. Grown at room temperature, the thin film can be produced even on a flexible substrate sensitive to heat.

### Reference Sign List

1, 1A, 24, 25, 32: thermoelectric conversion element
20, 20A, 30: thermoelectric conversion device
22, 22A: substrate
23, 23A: power generator
31: hollow member

## Claims

1. A thermoelectric conversion element (1; 1A; 24; 25; 32) made of one of:
a first material with a stoichiometric composition of Fe₃X where X is a main-group element or a transition element;
a second material with an off-stoichiometric composition in which a composition ratio of Fe to X deviates from that of the first material, the second material having a D0₃-type crystal structure or a B2-type crystal structure;
a third material obtained by substituting a part of Fe sites in the first material or a part of Fe sites in the second material by a main-group metal element or a transition element other than X;
a fourth material with a composition of Fe₃M1₁₋ₓM2ₓ where 0<x<1, and M1 and M2 are main-group elements different from each other; and
a fifth material obtained by substituting a part of Fe sites in the first material by a transition element other than X and substituting a part of X sites in the first material by a main-group metal element other than X, wherein
the first material, the second material, the third material, the fourth material, and the fifth material exhibit an anomalous Nernst effect.

2. The thermoelectric conversion element (1; 1A; 24; 25; 32) according to claim 1, wherein
the first material, the second material, the third material, the fourth material, or the fifth material has a Nernst coefficient which is constant within a predefined temperature range including room temperature.

3. The thermoelectric conversion element (1; 1A; 24; 25; 32) according to claim 1 or 2, wherein
the first material, the second material, the third material, the fourth material, or the fifth material is a single crystal.

4. The thermoelectric conversion element (1; 1A; 24; 25; 32) according to claim 1 or 2, wherein
the first material, the second material, the third material, the fourth material, or the fifth material is a polycrystal.

5. The thermoelectric conversion element (1; 1A; 24; 25; 32) according to claim 1 or 2, wherein
the first material, the third material, the fourth material, or the fifth material is amorphous.

6. The thermoelectric conversion element (1; 1A; 24; 25; 32) according to any one of claims 1 to 5, wherein
the X is Al, Ga, Ge, Sn, Si, Ti, Zr, Hf, V, Nb, Ta, Cr, Mo, W, Sc, Ni, Mn, or Co.

7. The thermoelectric conversion element (1; 1A; 24; 25; 32) according to any one of claims 1 to 6, wherein
the thermoelectric conversion element is a thin film with a thickness of 10 µm or less.

8. A thermoelectric conversion device (20; 20A) comprising:
a substrate (22; 22A); and
a power generator (23; 23A) provided on the substrate and including a plurality of thermoelectric conversion elements (1A; 24; 25), wherein
each of the plurality of thermoelectric conversion elements (1A; 24; 25) has a shape extending in one direction, and is made of a material identical to that of the thermoelectric conversion element according to any one of claims 1 to 7, and
the plurality of thermoelectric conversion elements (1A; 24; 25) are arranged in parallel to one another in a direction perpendicular to the one direction and electrically connected in series to one another.

9. The thermoelectric conversion device (20) according to claim 8, wherein
the plurality of thermoelectric conversion elements (24; 25) are arranged in a serpentine shape.

10. A thermoelectric conversion device (30) comprising:
the thermoelectric conversion element (32) according to any one of claims 1 to 7; and
a hollow member (31), wherein
the thermoelectric conversion element (32) is a sheet-shaped element or a wire rod covering an outer surface of the hollow member (31).

## Patentansprüche

1. Thermoelektrisches Wandlerelement (1; 1A; 24; 25; 32), das aus einem von Folgenden gefertigt ist:
einem ersten Material mit einer stöchiometrischen Zusammensetzung von Fe₃X, wobei X ein Hauptgruppenelement oder ein Übergangselement ist;
einem zweiten Material mit einer außerstöchiometrischen Zusammensetzung, bei der das Zusammensetzungsverhältnis von Fe zu X von dem des ersten Materials abweicht, wobei das zweite Material eine Kristallstruktur vom Typ D0₃ oder vom Typ B2 aufweist;
einem dritten Material, das durch Ersetzen eines Teils von Fe-Stellen in dem ersten Material oder eines Teils von Fe-Stellen in dem zweiten Material durch ein Metallelement der Hauptgruppe oder ein anderes Übergangselement als X erlangt wird;
einem vierten Material mit einer Zusammensetzung von Fe₃M1₁₋ₓM2ₓ, wobei 0<x<1 und M1 und M2 voneinander verschiedene Hauptgruppenelemente sind; und
einem fünften Material, das durch Ersetzen eines Teils von Fe-Stellen in dem ersten Material durch ein anderes Übergangselement als X und durch Ersetzen eines Teils von X-Stellen in dem ersten Material durch ein anderes Hauptgruppenelement als X erlangt wird, wobei
das erste Material, das zweite Material, das dritte Material, das vierte Material und das fünfte Material einen anomalen Nernst-Effekt aufweisen.

2. Thermoelektrisches Wandlerelement (1; 1A; 24; 25; 32) nach Anspruch 1, wobei
das erste Material, das zweite Material, das dritte Material, das vierte Material oder das fünfte Material einen Nernst-Koeffizienten aufweist, der innerhalb eines vordefinierten Temperaturbereichs einschließlich Raumtemperatur konstant ist.

3. Thermoelektrisches Wandlerelement (1; 1A; 24; 25; 32) nach Anspruch 1 oder 2, wobei
das erste Material, das zweite Material, das dritte Material, das vierte Material oder das fünfte Material ein Einkristall ist.

4. Thermoelektrisches Wandlerelement (1; 1A; 24; 25; 32) nach Anspruch 1 oder 2, wobei
das erste Material, das zweite Material, das dritte Material, das vierte Material oder das fünfte Material ein Polykristall ist.

5. Thermoelektrisches Wandlerelement (1; 1A; 24; 25; 32) nach Anspruch 1 oder 2, wobei
das erste Material, das dritte Material, das vierte Material oder das fünfte Material amorph ist.

6. Thermoelektrisches Wandlerelement (1; 1A; 24; 25; 32) nach einem der Ansprüche 1 bis 5, wobei
das X Al, Ga, Ge, Sn, Si, Ti, Zr, Hf, V, Nb, Ta, Cr, Mo, W, Sc, Ni, Mn oder Co ist.

7. Thermoelektrisches Wandlerelement (1; 1A; 24; 25; 32) nach einem der Ansprüche 1 bis 6, wobei
das thermoelektrische Wandlerelement ist ein Dünnfilm mit einer Stärke von 10 µm oder weniger ist.

8. Thermoelektrische Wandlervorrichtung (20; 20A), umfassend:
ein Substrat (22; 22A); und
einen Leistungsgenerator (23; 23A), der auf dem Substrat bereitgestellt ist und eine Vielzahl von thermoelektrischen Wandlerelementen (1A; 24; 25) beinhaltet, wobei
jedes der Vielzahl von thermoelektrischen Wandlerelementen (1A; 24; 25) eine Form aufweist, die sich in eine Richtung erstreckt, und aus einem Material gefertigt ist, das identisch wie jenes des thermoelektrischen Wandlerelements nach einem der Ansprüche 1 bis 7 ist, und
die Vielzahl von thermoelektrischen Wandlerelementen (1A; 24; 25) parallel zueinander in einer Richtung senkrecht zu der einen Richtung angeordnet und elektrisch in Reihe miteinander verbunden sind.

9. Thermoelektrische Wandlervorrichtung (20) nach Anspruch 8, wobei
die Vielzahl von thermoelektrischen Wandlerelementen (24; 25) serpentinenförmig angeordnet ist.

10. Thermoelektrische Wandlervorrichtung (30), umfassend:
das thermoelektrische Wandlerelement (32) nach einem der Ansprüche 1 bis 7; und
einen hohlen Körper (31), wobei
das thermoelektrische Wandlerelement (32) ein blattförmiges Element oder ein Walzdraht ist, das/der eine Außenfläche des hohlen Körpers (31) bedeckt.

## Revendications

1. Élément de conversion thermoélectrique (1 ; 1A ; 24 ; 25 ; 32) constitué de l'un parmi :
un premier matériau avec une composition stœchiométrique de Fe₃X où X est un élément de groupe principal ou un élément de transition ;
un deuxième matériau avec une composition non stœchiométrique dans laquelle un rapport de composition de Fe et de X s'écarte de celui du premier matériau, le deuxième matériau ayant une structure cristalline de type D0₃ ou une structure cristalline de type B2 ;
un troisième matériau obtenu en substituant une partie de sites Fe dans le premier matériau ou une partie de sites Fe dans le deuxième matériau par un élément métallique de groupe principal ou un élément de transition différent de X ;
un quatrième matériau avec une composition de Fe₃M1₁₋ₓM2ₓ où 0 < x < 1, et M1 et M2 sont des éléments de groupe principal différents l'un de l'autre ; et
un cinquième matériau obtenu en substituant une partie de sites Fe dans le premier matériau par un élément de transition différent de X et en substituant une partie de sites X dans le premier matériau par un élément métallique de groupe principal différent de X, dans lequel
le premier matériau, le deuxième matériau, le troisième matériau, le quatrième matériau et le cinquième matériau présentent un effet de Nernst anormal.

2. Élément de conversion thermoélectrique (1 ; 1A ; 24 ; 25 ; 32) selon la revendication 1, dans lequel
le premier matériau, le deuxième matériau, le troisième matériau, le quatrième matériau ou le cinquième matériau a un coefficient de Nernst qui est constant au sein d'une plage de températures prédéfinie incluant la température ambiante.

3. Élément de conversion thermoélectrique (1 ; 1A ; 24 ; 25 ; 32) selon la revendication 1 ou 2, dans lequel
le premier matériau, le deuxième matériau, le troisième matériau, le quatrième matériau ou le cinquième matériau est un monocristal.

4. Élément de conversion thermoélectrique (1 ; 1A ; 24 ; 25 ; 32) selon la revendication 1 ou 2, dans lequel
le premier matériau, le deuxième matériau, le troisième matériau, le quatrième matériau ou le cinquième matériau est un polycristal.

5. Élément de conversion thermoélectrique (1 ; 1A ; 24 ; 25 ; 32) selon la revendication 1 ou 2, dans lequel
le premier matériau, le troisième matériau, le quatrième matériau ou le cinquième matériau est amorphe.

6. Élément de conversion thermoélectrique (1 ; 1A ; 24 ; 25 ; 32) selon l'une quelconque des revendications 1 à 5, dans lequel
le X est Al, Ga, Ge, Sn, Si, Ti, Zr, Hf, V, Nb, Ta, Cr, Mo, W, Sc, Ni, Mn ou Co.

7. Élément de conversion thermoélectrique (1 ; 1A ; 24 ; 25 ; 32) selon l'une quelconque des revendications 1 à 6, dans lequel
l'élément de conversion thermoélectrique est un film mince avec une épaisseur de 10 µm ou moins.

8. Dispositif de conversion thermoélectrique (20 ; 20A) comprenant :
un substrat (22 ; 22A) ; et
un générateur de puissance (23 ; 23A) prévu sur le substrat et incluant une pluralité d'éléments de conversion thermoélectrique (1A ; 24 ; 25), dans lequel
chacun de la pluralité d'éléments de conversion thermoélectrique (1A ; 24 ; 25) a une forme s'étendant dans une première direction, et est constitué d'un matériau identique à celui de l'élément de conversion thermoélectrique selon l'une quelconque des revendications 1 à 7, et
la pluralité d'éléments de conversion thermoélectrique (1A ; 24 ; 25) sont agencés en parallèle les uns par rapport aux autres dans une direction perpendiculaire à la première direction et électriquement connectés en série les uns aux autres.

9. Dispositif de conversion thermoélectrique (20) selon la revendication 8, dans lequel
la pluralité d'éléments de conversion thermoélectrique (24 ; 25) sont agencés en une forme en serpentin.

10. Dispositif de conversion thermoélectrique (30) comprenant :
l'élément de conversion thermoélectrique (32) selon l'une quelconque des revendications 1 à 7 ; et
une pièce creuse (31), dans lequel
l'élément de conversion thermoélectrique (32) est un élément en forme de feuille ou un fil laminé recouvrant une surface externe de la pièce creuse (31).
